# EUROPEAN PATENT APPLICATION

(11) **EP 4 683 484 A1**
(43) Date of publication of application: **21.01.2026**
(21) Application number: 24189734.7
(22) Date of filing: 19.07.2024
(51) Int. Cl.: H10K 85/30, H10K 30/86, H10K 50/155

(54) **BINUCLEAR METAL COMPLEXES AND THE USE THEREOF IN ORGANIC ELECTRONICS**

(71) Applicant: CREDOXYS GmbH, 01187 Dresden (DE)
(72) Inventor: Steffen, WOLTERING, 01187 Dresden (DE); Till, VOGEL, 01187 Dresden (DE); Marcus, PAPMEYER, 01187 Dresden (DE); Sascha, DOROK, 01187 Dresden (DE)

(57) **Abstract**

The present invention relates to compounds of formula (I) as well as to their use as organic doping agent, as transport layer, as hole injection layer, as organic semiconductor itself, or as hole transport layer. The invention also relates to organic semiconductive materials, electronic components, semiconductor units, and doped semiconductor layers comprising the compounds of formula (I) as well as to a method to produce such a doped semiconductor layer.

## Description

The present invention relates to compounds of formula (I) as well as to their use as organic doping agent, as transport layer, as hole injection layer, as organic semiconductor itself, or as hole transport layer. The invention also relates to organic semiconductive materials, electronic components, semiconductor units, and doped semiconductor layers comprising the compounds of formula (I) as well as to a method to produce such a doped semiconductor layer.

### BACKGROUND OF THE INVENTION

Organic electronics focuses on the development, characterization and application of new materials, both based on small organic molecules and polymers with certain desired electronic properties for the production of electronic components.

These include, for example, organic field-effect transistors (OFETs), such as organic thin-film transistors (OTFTs), organic electroluminescent devices, such as organic light-emitting diodes (OLEDs), organic solar cells (OSCs), e.g. exciton solar cells, dye-sensitized solar cells (DSSCs), or perovskite solar cells; electrophotography, e.g., photoconductive materials in organic photoconductors (OPCs); organic optical detectors; organic photoreceptors; light-emitting electrochemical cells (LECs); and organic laser diodes.

It is known that organic semiconductor matrices can be strongly influenced in terms of their electrical conductivity by doping. Such organic semiconductor layers of semiconductor matrix material can be built either from compounds with electron donor properties (p-type conductors) or from compounds with electron acceptor properties (n-type conductors). Unlike inorganic semiconductors, organic semiconductors have very low intrinsic charge carrier density. To achieve good semiconductor properties, organic semiconductor matrix materials are therefore usually doped. For n-doping, strong electron donors (n-dopants) are used to transfer an electron to the LUMO (lowest unoccupied molecular orbital) of the semiconductor matrix (n-doping), resulting in a free electron on the matrix (SOMO - singly occupied molecular orbital). For p-doping, strong electron acceptors (p-dopants) are used to remove an electron from the HOMO (highest occupied molecular orbital) of the semiconductor matrix (p-doping), leaving a hole. In other words, for effective p-doping, the LUMO of the dopant must be similar or below the HOMO energy of the matrix. The p-dopant acts as an acceptor for an electron, leaving a moving hole (SOMO) in the matrix. Due to the requirement of such a deep LUMO of the p-dopant, only very few materials are suitable for an application as p-dopant.

Known p-dopants and/or hole injection materials for electron donor materials are electron acceptors such as tetracy-anoquione methane (TCNQ), 2,3,5,6-tetrafluorotetracy-ano-1 ,4-benzoquinone methane (F4TCNQ), trinaphthylenes (HATNA), metal oxides such as MoOs or WO₃, or radialene compounds as e.g. described in EP 2180029. The acceptor molecules generate so-called holes in the semiconductor matrix materials (hole transport materials) by electron transfer processes, and the conductivity of the semiconductor matrix material (hole transport material) is more or less changed depending on the number and mobility of the holes.

Known as a matrix material with hole transport properties are for example, N,N'-perarylated benzidines such as TPD or N,N',N"-perarylated starburst compounds such as the substance TDATA, or, however, also certain metal phthalocyanines, such as in particular zinc phthalocyanine ZnPc . Such kind of electron acceptor compounds are e.g. described in EP2180029 A1, which regards the use of radialene compounds as doping agents for an organic semiconductive matrix material.

However, the compounds or compound classes described above have disadvantages for technical use in the production of doped semiconductors or corresponding electronic components with such doped layers as they have too high absorption coefficients, are too volatile, exhibit an unstable evaporation rate, have a too low electron affinity and/or show low thermostability. A high absorption leads to an unwanted reduction of efficiency in light-emitting components (such as OLEDs) and light-converting components (such as solar cells). High volatility, unstable evaporation behaviour and low thermostability results in undesired irregularities in the performance of the electronic component and reduction of component stability. In addition, some of these substance classes have very high manufacturing costs.

Furthermore, there are new developments in the field of p-dopants, e.g. metal complexes are applied as p-dopants. A very promising class of p-dopants are based on Cerium (IV) complexes as described in EP 4029069 A1 or in EP 4305681A1. The continuous development of novel hole transport materials with unprecedented properties also requires the development of novel p-dopants with versatile doping properties.

Accordingly, there remains a need to improve semiconductor materials and of devices comprising these semiconductor materials and it is an object of the present invention to overcome the disadvantages of the state of the art, in particular to make new organic compounds available that can be used in particular as doping agent for the doping of organic semiconductors, that can furthermore be more readily handled in the production process and that result in electronic components whose organic semiconductive materials can be reproducibly manufactured. Furthermore, the present invention is providing a versatile structure class that allows the design of electron acceptor compounds by tethering different types of substituents. In particular, hole transport materials with a wide range of HOMO-levels shall be dopable by the new organic mesomeric compounds.

This object is solved by the independent claims of the present application. Preferred embodiments are disclosed in the subclaims.

### SUMMARY OF THE INVENTION

**A first object of the invention is an electronic component** comprising at least one compound of the formula (I)

[Ce⁴⁺]₂[(L)ₙ]⁸⁻ (I),

wherein n is an integer from 1 to 8,
wherein L is independently of each other a ligand with at least five carbon atoms.

**A further object of the invention is a compound** comprising at least one compound of formula (I)

[Ce⁴⁺]₂[(L)ₙ]⁸⁻ (I),

wherein n is an integer from 1 to 8,
wherein L is independently of each other a ligand with at least five carbon atoms,
with the proviso that compounds with the CAS-number 2097642-18-5, 1632455-28-7, 2097642-24-3, 2241999-19-7, 2097135-12-9, 2241999-18-6, 1624620-72-9, 1624620-73-0, 1626423-31-1 and 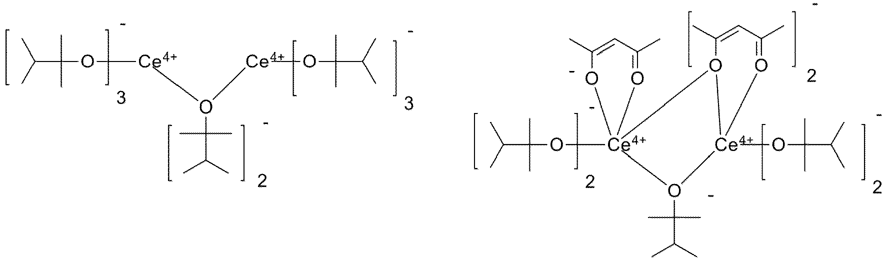 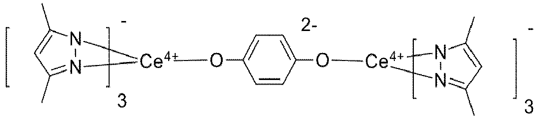
are excluded.

Another embodiment of the invention is the **electronic component** according to the invention in the form of an organic light-emitting diode, a photovoltaic cell, an organic solar cell, an organic diode, an organic sensor, an organic field effect transistor or an organic battery.

A further object of the invention is a **doped semiconductor layer** comprising at least one electron donor and at least one doping agent, wherein the doping agent is a compound of the formula (I) and/or formula (I.a) according to the invention. In a preferred embodiment, the electron donor is a triaryl amine-based or a carbazole compound, comprising at least one or more nitrogen atoms exhaustively substituted by aromatic moieties. The doping agent is preferably a compound of formula (I), in particular compounds of formula (I.a), preferably compounds as listed in tables 1, 2, 3, 4, 5, 6 or 7.

A further object of the invention is a **use** of at least one compound of formula (I), in particular compounds of formula (I.a), preferably compounds as listed in tables 1, 2, 3, 4, 5, 6 or 7.
- as semiconductor, in particular as organic semiconductor,
- as a redox doping agent in semiconductor layers, especially as p-dopant in hole transport layers,
- as p-dopant in hole transport layers,
- as charge injector in a charge injection layer,
- as charge extractor in a charge extraction layer,
- as a sublayer of a pn-junction, especially as a sublayer of a charge-generation layer and/or a charge conversion layer, in particular a p-type charge generation layer,
- as acceptor compound in charge-transfer complexes,
- as cathode material in organic and/or redox flow batteries,
- as electrochromic material.

A further object of the invention is a use of at least one compound of formula (I) and/or formula (I.a), **as doping agent** for the doping of an semiconductive layer, as absorbing layer, as charge injection layer, or as semiconductor itself.

A further object of the invention is a use of reduced species and/or twice reduced species of the compound of the general formula (I) and/or formula (I.a) as defined herein or of charge transfer complexes of a compound of formula (I) and/or formula (I.a) as defined herein **with electron donors as semiconductor or as electrochromic material.**

A further object of the invention is a **method for the preparation of a doped semiconductor layer,** wherein a hole transport material and a compound of general formula (I) and/or formula (I.a) according to the invention is used. The method comprises at least one of the following steps:
(a) Simultaneous evaporation of the hole transport material and the compound of formula (I) and/or formula (I.a).
(b) Evaporation of a pre-mixed material containing the hole transport material and at least one compound of general formula (I) and/or formula (I.a) from one single source.
(c) Sequential deposition of the hole transport material and at least one compound of general formula (I) and/or formula (I.a).
(d) Doping of a hole transport (HT) layer by a solution containing at least one compound of general formula (I) and/or formula (I.a) followed by evaporation of the solvent by thermal treatment.
(e) Surface doping of a layer of a hole transport material by a layer of at least one compound of general formula (I) and/or formula (I.a) applied to one or both surfaces of the layer of a hole transport material.
(f) Preparing a solution of a hole transport material and at least one compound of general formula (I) and/or formula (I.a) and forming a film from the solution.

The invention will be illustrated further with reference to the examples that follow, without restricting the scope to the specific embodiments described. The invention includes all combinations of described and especially of preferred features that do not exclude each other.

### DESCRIPTION OF THE INVENTION

The invention has the following advantages:
- The compounds of formula (I) and/or formula (I.a) have only low production costs.
- The compounds of formula (I) and/or formula (I.a) have a wide application range, in particular the compounds of formula (I) and/or formula (I.a) can be used for a p-side application in organic electronic devices
- The compounds of formula (I) and/or formula (I.a) are advantageously suitable as electron acceptors for use as p-dopants and as electron transport materials in organic-electronic components.
- The compounds of formula (I) and/or formula (I.a) according to the invention lead to a better conductivity of the semiconductor layers as compared to known electron acceptors.
- Furthermore, the compounds of formula (I) and/or formula (I.a) are characterized by a higher doping efficiency and can accept up to two electrons per molecule.
- Doped layers comprising a matrix material and a compound of formula (I) and/or formula (I.a) show only a low absorption, in particular in the visible range and in the near-infrared range. Therefore, parasitic absorption and emission can be reduced or even prevented.
- The compounds of formula (I) and/or formula (I.a) show good evaporation behavior in high vacuum during processing, in particular a high evaporation temperature.
- The compounds of formula (I) and/or formula (I.a) are suitable for the production of organic and hybrid opto-electronic components, both by means of solvent processing and by vacuum reprocessing.
- Due to their bimetallic character, the compounds of formula (I) and/or formula (I.a) provide two electron accepting sides, i.e. the compounds tend to accept two electrons. Accordingly, the resulting compounds formed in the vicinity of electron donors are bisanions or dianions. Advantageously, the compounds according to the invention tend to accept more than one electron and therefore show a high doping efficiency.
In addition, the resulting bisanions or dianions have a very low absorption, especially in the visible and near-infrared range.

The expression "halogen" denotes in each case fluorine, bromine, chlorine or iodine, particularly fluorine, chlorine and bromine.

In the context of the invention, the prefix Cₙ-Cₘ indicates the number of carbon atoms that a molecule or residue designated thereby may contain.

In the context of the invention, alkyl refers to unbranched or branched saturated hydro-carbon groups.

In the context of the invention, the term "cycloalkyl" refers to unbranched or branched saturated cyclic hydro-carbon groups. Examples are cyclohexyl, cyclopentyl, methylcyclohexyl.

In the context of the invention, "haloalkylaryl" refers to mono- or polynuclear aromatic hydrocarbon radicals with usually 6 to 14, especially preferably 6 to 10 carbon atoms with polyhalogenated side chains. Examples of haloalkylaryl are trifluoromethylphenyl, trifluoromethylnaphtyl.

In the context of the invention, the expression C₁-C₄-alkyl refers to unbranched or branched saturated hydrocarbon groups having 1 to 4 carbon atoms. C1-C4-alkyl are e.g. methyl, ethyl, propyl, 1-methylethyl, butyl, 1-methylpropyl or 2-methylpropyl, 1,1-dimethylethyl.

The expression "aryl" comprises in the context of the invention mono- or polynuclear aromatic hydrocarbon radicals with usually 6 to 14, especially preferably 6 to 10 carbon atoms. Examples of aryl are especially phenyl, naphthyl, indenyl, fluorenyl, anthracenyl, phenanthrenyl, naphthacenyl, chrysenyl, pyrenyl, etc. and especially phenyl or naphthyl.

The term heteroaryl (hetaryl) includes mono- and polycyclic (e.g. bicyclic or tricyclic) heteroaromatic radicals having 3 to 13 carbon atoms, wherein hetaryl has 1, 2, 3 or 4 identical or different heteroatoms or heteroatom-containing groups as ring members, selected from N, O, S, SO and SO₂, preferably selected from N, O and S. The hetaryl group may be attached to the remainder of the molecule via a ring carbon or via a ring heteroatom e.g. via a nitrogen. Examples of 5- or 6-membered aromatic hetero-cyclic rings (also called heteroaromatic rings or hetaryl) are 2-pyrrolyl, 3-pyrrolyl, 3-pyrazolyl, 4-pyrazolyl, 5-pyrazolyl, 2-imidazolyl, 4-imidazolyl, 1,3,4-triazol-2-yl, 2-pyridinyl, 3-pyridinyl, 4-pyridinyl, 3-pyridazinyl, 4-pyridazinyl, 2-pyrimidinyl, 4-pyrimidinyl, 5-pyrimidinyl and 2-pyrazinyl. Examples of 10-membered aromatic heterocyclic rings are 2-quinolinyl, 3-quinolinyl, 1-isoquinolinyl.

In the context of the invention, the term "arylene" refers to arylene groups which are bivalent groups derived from aryl groups by removal of a further hydrogen atom from a further ring carbon atom, wherein the aromatic hydrocarbon biradicals have usually 6 to 14, especially preferably 6 to 10 carbon atoms . A synonym is arenediyl groups. It represent in particular any monocyclic or polycyclic hydrocarbon group comprising at least one aromatic cycle wherein all ring-atoms are carbon, from which two hydrogen have been removed to create a divalent group. Aylene groups can be partially or fully substituted. Examples of arylene are 1,3-phenylene, 1,2-phenylene 1 ,2-naphtylene, 1,5-naphthylene, 1,7-naphthylene, 4,4'-biphenyl, 3,3'-biphenyl, 3,7-fluorene.

In the context of this invention, the term "heteroarylene" (hetarylene) refers to heteroarylene groups which are bivalent (biradical) groups derived from heteroaryl groups. The heteroaromatic biradicals have 3 to 13 carbon atoms, wherein hetarylene has 1, 2, 3 or 4 identical or different heteroatoms or heteroatom-containing groups as ring members, selected from N, O, S, SO and SO₂, preferably selected from N, O and S. Hetarylene groups can be partially or fully substituted. The hetarylene group may be attached to the remainder of the molecule via a ring carbon or via a ring heteroatom e.g. via a nitrogen. Examples of hetarylene include 2,6-pyridylene, 2,4-pyrimidylene, 2,5-pyrazinylene, or 2,5-thiophenylene.

In the context of the invention, the term "alkylene" refers to alkylene groups which are bivalent groups derived from alkyl groups by removal of a further hydrogen atom. Alkylene groups are for example methylene, ethylene, n-propylene and n-butylene.

In the context of the invention, the term "haloalkylene" refers to haloalkylene groups which are bivalent groups derived from partially or fully halogenated alkyl groups by removal of a further hydrogen atom. Alkylene groups are for example difluoromethylene, tetraflurorethylene, hexafluoropropylene and octafluorobutylene.

In the context of the invention, formula (II.a) represents an exemplary mesomeric frontier structure to which the ligands L are not restricted.

In the context of the invention, a bidentate ligand (also called a bidentate) is a ligand that binds to an individual metal atom (cerium atom) with two atoms. A bis-bidentate ligand is a ligand that binds to each of the two metal atoms with two atoms. A bis-tetradentate ligand is a ligand that binds to each of the two metal atoms with four atoms.

The term charge transfer complexes describe a supramolecular assembly of an electron donor, for example an hole transport material and an electron acceptor, for example a p-dopant.

The expression "CN" denotes the cyano group (-C=N).

The expression "haloalkyl" refers to partially or fully halogenated alkyl chains. In other words, one or more hydrogen atoms, for example 1, 2, 3, 4 or 5 hydrogen atoms bonded to one or more carbon atoms of alkyl, are replaced by a halogen atom, in particular by fluorine or chlorine.

### COMPOUNDS OF FORMULA (I) AND/OR FORMULA (I.A)

A preferred embodiment of the invention is a compound of formula (I)

[Ce⁴⁺]₂[(L)ₙ]⁸⁻ (I),

wherein n is an integer from 1 to 8,
wherein L is independently of each other a ligand with at least five carbon atoms,
wherein L is similar or at least one L differs from the other L,
with the proviso that compounds with the CAS-number 2097642-18-5, 1632455-28-7, 2097642-24-3, 2241999-19-7, 2097135-12-9, 2241999-18-6, 1624620-72-9, 1624620-73-0, 1626423-31-1 and 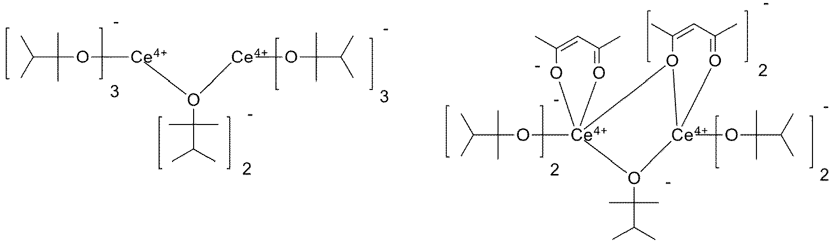 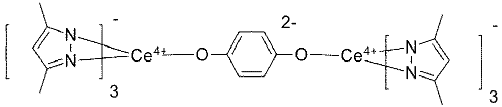 are excluded.

A ligand containing five carbon atoms is for example hexafluoroacetylacetonate.

The compound of formula (I) is preferably electronically neutral, i.e. the compound of formula (I) is electrically non-charged.

In one embodiment, n is selected from 2, 4, 8. As an advantage, the synthesis of these materials is simple.

In one embodiment, n is 2 or n is 4. As an advantage, the synthesis of these materials is even more simple.

In one embodiment, n is 4 and L is a bis-bidentate ligand.

In one embodiment, n is 2 and L is a bis-tetradentate ligand.

Preferred is a compound according to the invention, wherein n is 4 and L is a bis-bidentate ligand, comprising at least one compound of the formula (I.a):

[Ce⁴⁺]₂L_{A}²⁻LB²⁻L_{C}²⁻L_{D}²⁻ (I.a)

or their single reduced species or their twice reduced species or their charge transfer complexes with donors, wherein L_{A},L_{B},L_{C},L_{D} have the same or different meanings,
wherein
L_{A}, L_{B}, L_{C} and L_{D} are each a bis-bidentate ligand independently selected from formula (Il.a) 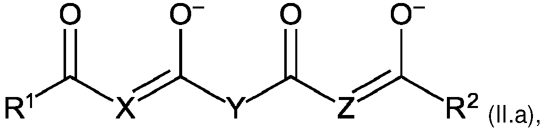 wherein
**X** is selected from C-H, nitrogen (N), C-CF₃ and C-R³;
**Z** is selected from C-H, nitrogen (N), C-CF₃ and C-R⁴;
**R¹ and R²** independently from each other represent C₆-C₁₄-aryl,4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl and C₁-C₆-haloalkyl,
   wherein aryl and heteroaryl are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyl, or C₆-C₁₄-aryl, which is unsubstituted or substituted by 1, 2 or 3 identical or different radicals selected from F, CN, C₁-C₄-alkyl and C₁-C₄-haloalkyl;
**R³ and R⁴** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl or C₁-C₆-haloalkyl;
   C₅-C₁₄-aryl and heteroaryl are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyl, and C₆-C₁₄-aryl, which is unsubstituted or substituted by 1, 2 or 3 identical or different radicals selected from F, CN, C₁-C₄-alkyl and C₁-C₄-haloalkyl;
wherein
   **Y** is selected from C₆-C₁₄-arylene, 4- to 14-membered heteroarylene having 1, 2 or 3 identical or different heteroatoms or heteroatom-containing groups as ring members, selected from N, O, S, SO and SO₂, C₁-C₁₀-alkylene, C₃-C₆-cycloalkylene, C₃-C₆-cycloalkenylene, C₁-C₁₀-haloalkylene, C₁-C₁₀-haloalkylarylene, S, S-O, O, P-**R⁶**, P-O-R⁷, Si-(R⁸)₂, B-R⁹, and N-R¹⁰;
   wherein arylene and heteroarylene are unsubstituted or substituted by 1, 2, 3, 4 or 5 identical or different radicals R⁵;
      wherein R⁵ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
   wherein **R⁶** is selected from C₁-C₄-alkyl, C₁-C₄-haloalkyl, or C₆-C₁₄-aryl, which is unsubstituted or substituted by 1, 2 or 3 identical or different radicals selected from F, CN, C₁-C₄-alkyl and C₁-C₄-haloalkyl;
   wherein **R⁷** is selected from C₁-C₄-alkyl, C₁-C₄-haloalkyl and C₆-C₁₄-arylene, which is unsubstituted or substituted by 1, 2 or 3 identical or different radicals selected from F, CN, C₁-C₄-alkyl and C₁-C₄-haloalkyl;
   wherein **R⁸** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
   wherein **R⁹** is selected from C₁-C₄-alkyl, C₁-C₄-haloalkyl and C₆-C₁₄-arylene, which is unsubstituted or substituted by 1, 2 or 3 identical or different radicals selected from F, CN, C₁-C₄-alkyl and C₁-C₄-haloalkyl;
   wherein **R¹⁰** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.

Preferred is a compound according to the invention, wherein n is 4 and L is a bis-bidentate ligand, comprising at least one compound of the formula (I.a):

[Ce⁴⁺]₂L_{A}²⁻L_{B}²⁻L_{C}²⁻L_{D}²⁻ (I.a)

or their reduced species or their twice reduced species or their charge transfer complexes with donors, wherein L_{A},L_{B},L_{C},L_{D} have the same or different meanings,
wherein
L_{A}, L_{B}, L_{C} and L_{D} are each a bis-bidentate ligand independently selected from formula (II.a) 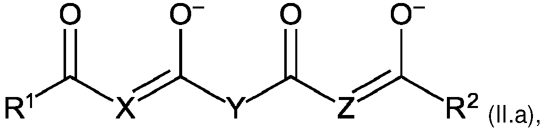 wherein
**X** is selected from C-H, nitrogen (N), C-CF₃ and C-R³;
**Z** is selected from C-H, nitrogen (N), C-CF₃ and C-R⁴;
**R¹ and R²** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkylor C₁-C₆-haloalkyl,
   wherein aryl and heteroaryl are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyland C₆-C₁₄-aryl, which is unsubstituted or substituted by 1, 2 or 3 identical or different radicals selected from F, CN, C₁-C₄-alkyl and C₁-C₄-haloalkyl;
**R³ and R⁴** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl, C₁-C₆-haloalkyl,
   wherein aryl and heteroaryl are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyland C₆-C₁₄-aryl, which is unsubstituted or substituted by 1, 2 or 3 identical or different radicals selected from F, CN, C₁-C₄-alkyl and C₁-C₄-haloalkyl;
wherein
   **Y** is selected from C₆-C₁₄-arylene, 4- to 14-membered heteroarylene having 1, 2 or 3 identical or different heteroatoms or heteroatom-containing groups as ring members, selected from N, O, S, SO and SO₂, C₁-C₁₀-alkylene, C₃-C₆-cycloalkylene, C₃-C₆-cycloalkenylene, C₁-C₁₀-haloalkylene or C₁-C₁₀-haloalkylarylene;
   wherein arylene and heteroarylene are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyl and C₆-C₁₄-arylene, which is unsubstituted or substituted by 1, 2 or 3 identical or different radicals selected from F, CN, C₁-C₄-alkyl and C₁-C₄-haloalkyl.

In one embodiment, X is C-H.

In one embodiment Z is C-H.

In another embodiment, X is C-H or Z is C-H.

In one embodiment, X is C-H and Z is C-H.

In one embodiment of the electronic component, in compounds of formula (II.a) Y is selected from n-C₃F₆, n-C₄F₈, n-C₅F₁₀, n-C₆F₁₂, and one of the following formulas: 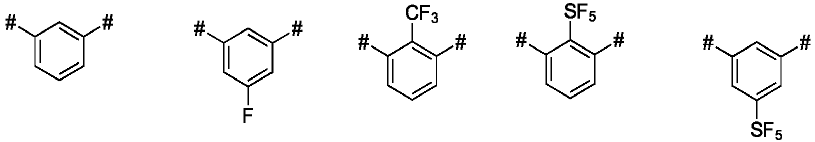 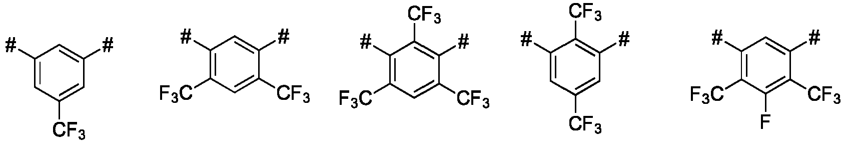 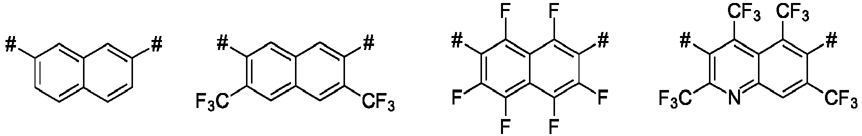 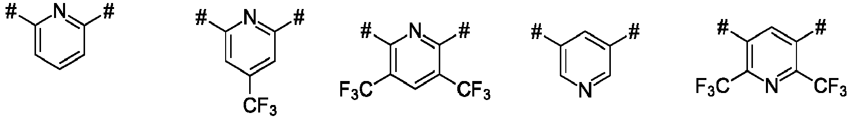 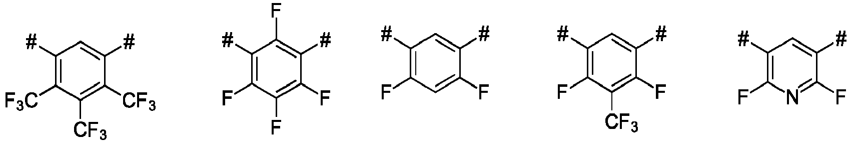 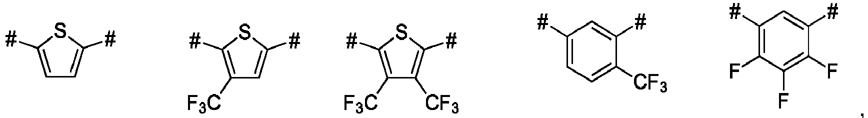 wherein # denotes the bond to the remaining molecule of formula (II.a).

**Preferred is an electronic component** according to the invention, wherein in compounds of formula (II.a) each of R¹, R², R³, and R⁴ can be independently selected from CF₃, C₂F₅, n-C₃F₇, n-C₄F₉, or one of the formulas (III.1) - (III.48): 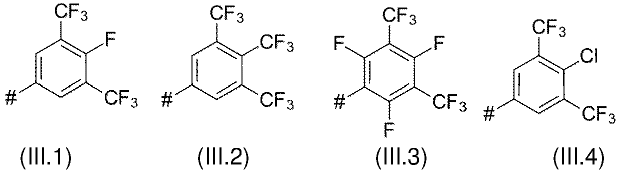 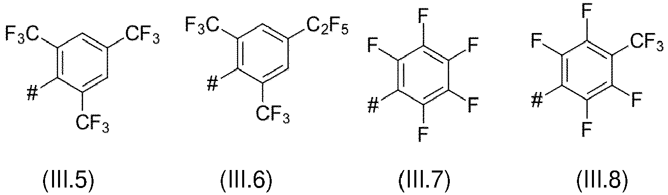 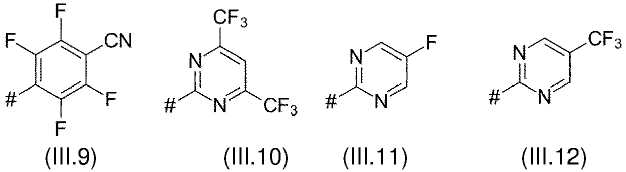 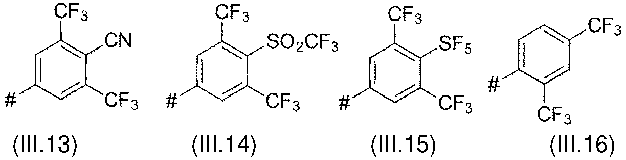 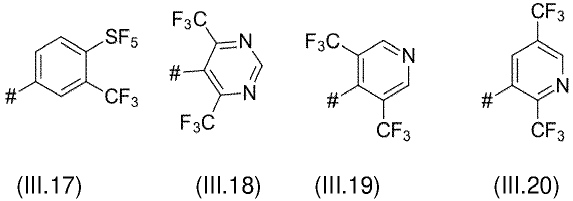 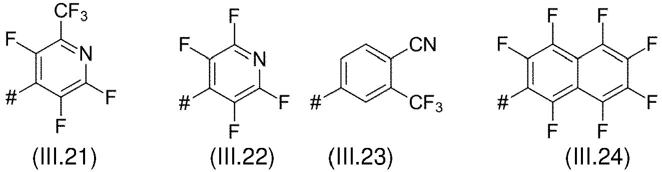 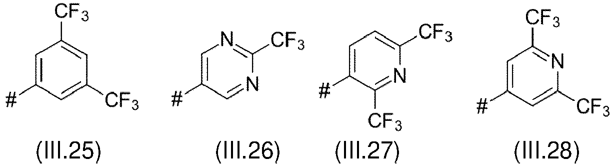 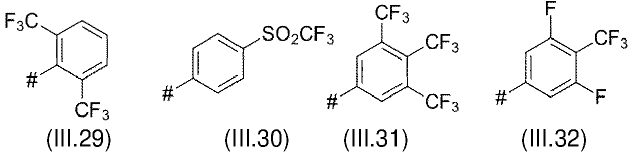 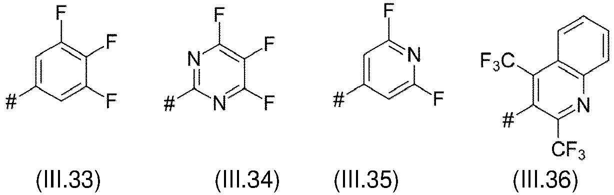 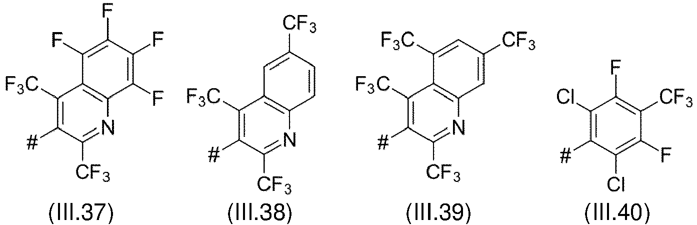 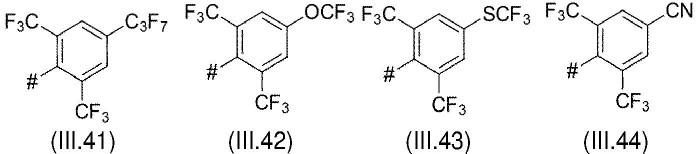 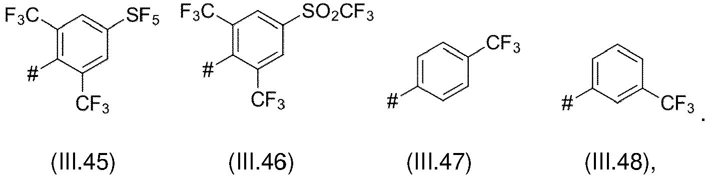 wherein # denotes the bond to the remaining molecule of formula (II.a).

In one embodiment, L_{A}, L_{B}, L_{C} and L_{D} have the same meanings.

In another embodiment at least one ligand of L_{A}, L_{B}, L_{C} and L_{D} has a different meaning than the other ligands.

### Tables with preferred compounds:

Preferred is a compound according to formula (I.b),

[Ce⁴⁺]₂L_{E}²⁻L_{F}²⁻L_{G}²⁻L_{H}²⁻ (I.b)

or their single reduced species or their twice reduced species or their charge transfer complexes with donors,
in which / wherein L_{E}, L_{F}, L_{G} and L_{H} have the same meanings and are a bis-bidentate ligand selected from formula (II.d), 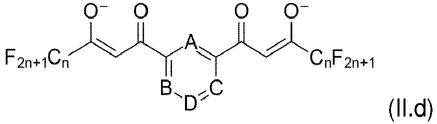 wherein n=1,
and A, B, C, and D are each selected from the definition given in one line of the following table 1.

**Table 1:**

| Entry | A= | B= | C= | D= |
|---|---|---|---|---|
| 1 | CH | CH | CH | CH |
| 2 | CH | CCF₃ | CH | CH |
| 3 | CH | CCF₃ | CCF₃ | CH |
| 4 | CH | CCF₃ | CH | CCF₃ |
| 5 | CH | CCF₃ | CCF₃ | CCF₃ |
| 6 | CH | CH | CH | CCF₃ |
| 7 | CCF₃ | CH | CH | CH |
| 8 | CCF₃ | CCF₃ | CH | CH |
| 9 | CCF₃ | CCF₃ | CCF₃ | CH |
| 10 | CCF₃ | CCF₃ | CH | CCF₃ |
| 11 | CCF₃ | CCF₃ | CCF₃ | CCF₃ |
| 12 | CCF₃ | CH | CH | CCF₃ |
| 13 | CH | CF | CH | CH |
| 14 | CH | CF | CF | CH |
| 15 | CH | CF | CH | CF |
| 16 | CH | CF | CF | CF |
| 17 | CH | CH | CH | CF |
| 18 | CF | CH | CH | CH |
| 19 | CF | CF | CH | CH |
| 20 | CF | CF | CF | CH |
| 21 | CF | CF | CH | CF |
| 22 | CF | CF | CF | CF |
| 23 | CF | CH | CH | CF |
| 24 | N | CH | CH | CH |
| 25 | N | CCF₃ | CH | CH |
| 26 | N | CCF₃ | CCF₃ | CH |
| 27 | N | CCF₃ | CH | CCF₃ |
| 28 | N | CCF₃ | CCF₃ | CCF₃ |
| 29 | N | CH | CH | CCF₃ |
| 30 | CH | N | CH | CH |
| 31 | CH | N | CCF₃ | CH |
| 32 | CH | N | CH | CCF₃ |
| 33 | CH | N | CCF₃ | CCF₃ |
| 34 | CCF₃ | N | CH | CH |
| 35 | CCF₃ | N | CCF₃ | CH |
| 36 | CCF₃ | N | CH | CCF₃ |
| 37 | CCF₃ | N | CCF₃ | CCF₃ |
| 38 | CH | CCF₃ | CH | N |
| 39 | CH | CCF₃ | CCF₃ | N |
| 40 | CH | CH | CH | N |
| 41 | CCF₃ | CCF₃ | CH | N |
| 42 | CCF₃ | CCF₃ | CCF₃ | N |
| 43 | CCF₃ | CH | CH | N |
| 44 | N | CH | CH | N |
| 45 | N | CCF₃ | CH | N |
| 46 | N | CCF₃ | CCF₃ | N |
| 47 | CH | CCF₃ | CH | C-Aryl |
| 48 | CH | CCF₃ | CCF₃ | C-Aryl |
| 49 | CH | CH | CH | C-Aryl |
| 50 | CCF₃ | CCF₃ | CH | C-Aryl |
| 51 | CCF₃ | CCF₃ | CCF₃ | C-Aryl |
| 52 | CCF₃ | CH | CH | C-Aryl |
| 53 | CH | N | N | CH |
| 54 | CH | N | N | CCF₃ |
| 55 | CCF₃ | N | N | CH |
| 56 | CCF₃ | N | N | CCF₃ |
| 57 | N | N | CH | CH |
| 58 | N | N | CCF₃ | CH |
| 59 | N | N | CH | CCF₃ |
| 60 | N | N | CCF₃ | CCF₃ |
| 61 | N | N | N | CH |
| 62 | N | N | N | CCF₃ |
| 63 | CF | CCF₃ | CF | CF |
| 64 | CF | CCF₃ | CCF₃ | CF |
| 65 | CF | CCF₃ | CF | CCF₃ |
| 66 | CF | CCF₃ | CCF₃ | CCF₃ |
| 67 | CF | CF | CF | CCF₃ |
| 68 | CCF₃ | CF | CF | CF |
| 69 | CCF₃ | CCF₃ | CF | CF |
| 70 | CCF₃ | CCF₃ | CCF₃ | CF |
| 71 | CCF₃ | CCF₃ | CF | CCF₃ |
| 72 | CCF₃ | CCF₃ | CCF₃ | CCF₃ |
| 73 | CCF₃ | CF | CF | CCF₃ |
| 74 | CH | CCF₃ | CF | CF |
| 75 | CH | CCF₃ | CCF₃ | CF |
| 76 | CH | CCF₃ | CF | CCF₃ |
| 77 | CH | CF | CH | COCF₃ |
| 78 | CH | CF | CF | COCF₃ |
| 79 | CH | CH | CH | COCF₃ |
| 80 | CF | CF | CH | COCF₃ |
| 81 | CF | CF | CF | COCF₃ |
| 82 | CF | CH | CH | COCF₃ |
| 83 | CH | CF | CH | CSO₂CF₃ |
| 84 | CH | CF | CF | CSO₂CF₃ |
| 85 | CH | CH | CH | CSO₂CF₃ |
| 86 | CF | CF | CH | CSO₂CF₃ |
| 87 | CF | CF | CF | CSO₂CF₃ |
| 88 | CF | CH | CH | CSO₂CF₃ |
| 89 | CH | CF | CH | CSF₅ |
| 90 | CH | CF | CF | CSF₅ |
| 91 | CH | CH | CH | CSF₅ |
| 92 | CF | CF | CH | CSF₅ |
| 93 | CF | CF | CF | CSF₅ |
| 94 | CF | CH | CH | CSF₅ |
| 95 | CH | C-Aryl | CH | CH |
| 96 | CH | C-Aryl | CCF₃ | CH |
| 97 | CH | C-Aryl | CH | CCF₃ |
| 98 | CH | C-Aryl | CCF₃ | CCF₃ |
| 99 | CCF₃ | C-Aryl | CH | CH |
| 100 | CCF₃ | C-Aryl | CCF₃ | CH |
| 101 | CCF₃ | C-Aryl | CH | CCF₃ |
| 102 | CCF₃ | C-Aryl | CCF₃ | CCF₃ |
| 103 | CH | C-Aryl | C-Aryl | CH |
| 104 | CH | C-Aryl | C-Aryl | CCF₃ |
| 105 | CCF₃ | C-Aryl | C-Aryl | CH |
| 106 | CCF₃ | C-Aryl | C-Aryl | CCF₃ |
| 107 | CH | C-Aryl | C-Aryl | CF |
| 108 | CF | C-Aryl | C-Aryl | CH |
| 109 | CF | C-Aryl | C-Aryl | CF |
| 110 | CH | C-Aryl | C-Aryl | CSF₅ |
| 111 | CSF₅ | C-Aryl | C-Aryl | CH |
| 112 | CSF₅ | C-Aryl | C-Aryl | CSF₅ |
| 113 | CH | CSF₅ | CSF₅ | CCF₃ |
| 114 | CCF₃ | CSF₅ | CSF₅ | CH |
| 115 | CCF₃ | CSF₅ | CSF₅ | CCF₃ |
| 116 | CH | CSF₅ | CSF₅ | COCF₃ |
| 117 | COCF₃ | CSF₅ | CSF₅ | CH |
| 118 | COCF₃ | CSF₅ | CSF₅ | COCF₃ |
| 119 | N | CF | CH | CH |
| 120 | N | CF | CF | CH |
| 121 | N | CF | CH | CF |
| 122 | N | CF | CF | CF |
| 123 | N | CH | CH | CF |
| 124 | CH | N | CF | CH |
| 125 | CH | N | CH | CF |
| 126 | CH | N | CF | CF |
| 127 | CF | N | CH | CH |
| 128 | CF | N | CF | CH |
| 129 | CF | N | CH | CF |
| 130 | CF | N | CF | CF |
| 131 | CH | CF | CH | N |
| 132 | CH | CF | CF | N |
| 133 | CF | CF | CH | N |
| 134 | CF | CF | CF | N |
| 135 | CF | CH | CH | N |
| 136 | N | CF | CCF₃ | CCF₃ |
| 137 | N | CF | CF | CCF₃ |
| 138 | N | CF | CCF₃ | CF |
| 139 | N | CF | CF | CF |
| 140 | N | CCF₃ | CCF₃ | CF |
| 141 | CCF₃ | N | CF | CCF₃ |
| 142 | CCF₃ | N | CCF₃ | CF |
| 143 | CCF₃ | N | CF | CF |
| 144 | CF | N | CCF₃ | CCF₃ |
| 145 | CF | N | CF | CCF₃ |
| 146 | CF | N | CCF₃ | CF |
| 147 | CF | N | CF | CF |
| 148 | CCF₃ | CF | CCF₃ | N |
| 149 | CCF₃ | CF | CF | N |
| 150 | CF | CF | CCF₃ | N |
| 151 | CF | CF | CF | N |
| 152 | CF | CCF₃ | CCF₃ | N |
| 153 | CH | CSF₅ | CH | CH |
| 154 | CH | CSF₅ | CCF₃ | CH |
| 155 | CH | CSF₅ | CH | CCF₃ |
| 156 | CH | CSF₅ | CCF₃ | CCF₃ |
| 157 | CCF₃ | CSF₅ | CH | CH |
| 158 | CCF₃ | CSF₅ | CCF₃ | CH |
| 159 | CCF₃ | CSF₅ | CH | CCF₃ |
| 160 | CCF₃ | CSF₅ | CCF₃ | CCF₃ |
| 161 | CH | CSO₂CF₃ | CH | CH |
| 162 | CH | CSO₂CF₃ | CCF₃ | CH |
| 163 | CH | CSO₂CF₃ | CH | CCF₃ |
| 164 | CH | CSO₂CF₃ | CCF₃ | CCF₃ |
| 165 | CCF₃ | CSO₂CF₃ | CH | CH |
| 166 | CCF₃ | CSO₂CF₃ | CCF₃ | CH |
| 167 | CCF₃ | CSO₂CF₃ | CH | CCF₃ |
| 168 | CCF₃ | CSO₂CF₃ | CCF₃ | CCF₃ |

Preferred is a compound according to formula (I.b),

[Ce⁴⁺]₂L_{E}²⁻L_{F}²⁻L_{G}²⁻L_{H}²⁻ (I.b)

or their single reduced species or their twice reduced species or their charge transfer complexes with donors,
wherein L_{E}, L_{F}, L_{G} and L_{H} have the same meanings and are a bis-bidentateligand selected from formula (Il.d), 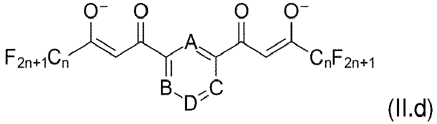 wherein n=2,
and A, B, C, and D are each selected from the definition given in one line of the following table 2.

**Table 2:**

| Entry | A= | B= | C= | D= |
|---|---|---|---|---|
| 1 | CH | CH | CH | CH |
| 2 | CH | CCF₃ | CH | CH |
| 3 | CH | CCF₃ | CCF₃ | CH |
| 4 | CH | CCF₃ | CH | CCF₃ |
| 5 | CH | CCF₃ | CCF₃ | CCF₃ |
| 6 | CH | CH | CH | CCF₃ |
| 7 | CCF₃ | CH | CH | CH |
| 8 | CCF₃ | CCF₃ | CH | CH |
| 9 | CCF₃ | CCF₃ | CCF₃ | CH |
| 10 | CCF₃ | CCF₃ | CH | CCF₃ |
| 11 | CCF₃ | CCF₃ | CCF₃ | CCF₃ |
| 12 | CCF₃ | CH | CH | CCF₃ |
| 13 | CH | CF | CH | CH |
| 14 | CH | CF | CF | CH |
| 15 | CH | CF | CH | CF |
| 16 | CH | CF | CF | CF |
| 17 | CH | CH | CH | CF |
| 18 | CF | CH | CH | CH |
| 19 | CF | CF | CH | CH |
| 20 | CF | CF | CF | CH |
| 21 | CF | CF | CH | CF |
| 22 | CF | CF | CF | CF |
| 23 | CF | CH | CH | CF |
| 24 | N | CH | CH | CH |
| 25 | N | CCF₃ | CH | CH |
| 26 | N | CCF₃ | CCF₃ | CH |
| 27 | N | CCF₃ | CH | CCF₃ |
| 28 | N | CCF₃ | CCF₃ | CCF₃ |
| 29 | N | CH | CH | CCF₃ |
| 30 | CH | N | CH | CH |
| 31 | CH | N | CCF₃ | CH |
| 32 | CH | N | CH | CCF₃ |
| 33 | CH | N | CCF₃ | CCF₃ |
| 34 | CCF₃ | N | CH | CH |
| 35 | CCF₃ | N | CCF₃ | CH |
| 36 | CCF₃ | N | CH | CCF₃ |
| 37 | CCF₃ | N | CCF₃ | CCF₃ |
| 38 | CH | CCF₃ | CH | N |
| 39 | CH | CCF₃ | CCF₃ | N |
| 40 | CH | CH | CH | N |
| 41 | CCF₃ | CCF₃ | CH | N |
| 42 | CCF₃ | CCF₃ | CCF₃ | N |
| 43 | CCF₃ | CH | CH | N |
| 44 | N | CH | CH | N |
| 45 | N | CCF₃ | CH | N |
| 46 | N | CCF₃ | CCF₃ | N |
| 47 | CH | CCF₃ | CH | C-Aryl |
| 48 | CH | CCF₃ | CCF₃ | C-Aryl |
| 49 | CH | CH | CH | C-Aryl |
| 50 | CCF₃ | CCF₃ | CH | C-Aryl |
| 51 | CCF₃ | CCF₃ | CCF₃ | C-Aryl |
| 52 | CCF₃ | CH | CH | C-Aryl |
| 53 | CH | N | N | CH |
| 54 | CH | N | N | CCF₃ |
| 55 | CCF₃ | N | N | CH |
| 56 | CCF₃ | N | N | CCF₃ |
| 57 | N | N | CH | CH |
| 58 | N | N | CCF₃ | CH |
| 59 | N | N | CH | CCF₃ |
| 60 | N | N | CCF₃ | CCF₃ |
| 61 | N | N | N | CH |
| 62 | N | N | N | CCF₃ |
| 63 | CF | CCF₃ | CF | CF |
| 64 | CF | CCF₃ | CCF₃ | CF |
| 65 | CF | CCF₃ | CF | CCF₃ |
| 66 | CF | CCF₃ | CCF₃ | CCF₃ |
| 67 | CF | CF | CF | CCF₃ |
| 68 | CCF₃ | CF | CF | CF |
| 69 | CCF₃ | CCF₃ | CF | CF |
| 70 | CCF₃ | CCF₃ | CCF₃ | CF |
| 71 | CCF₃ | CCF₃ | CF | CCF₃ |
| 72 | CCF₃ | CCF₃ | CCF₃ | CCF₃ |
| 73 | CCF₃ | CF | CF | CCF₃ |
| 74 | CH | CCF₃ | CF | CF |
| 75 | CH | CCF₃ | CCF₃ | CF |
| 76 | CH | CCF₃ | CF | CCF₃ |
| 77 | CH | CF | CH | COCF₃ |
| 78 | CH | CF | CF | COCF₃ |
| 79 | CH | CH | CH | COCF₃ |
| 80 | CF | CF | CH | COCF₃ |
| 81 | CF | CF | CF | COCF₃ |
| 82 | CF | CH | CH | COCF₃ |
| 83 | CH | CF | CH | CSO₂CF₃ |
| 84 | CH | CF | CF | CSO₂CF₃ |
| 85 | CH | CH | CH | CSO₂CF₃ |
| 86 | CF | CF | CH | CSO₂CF₃ |
| 87 | CF | CF | CF | CSO₂CF₃ |
| 88 | CF | CH | CH | CSO₂CF₃ |
| 89 | CH | CF | CH | CSF₅ |
| 90 | CH | CF | CF | CSF₅ |
| 91 | CH | CH | CH | CSF₅ |
| 92 | CF | CF | CH | CSF₅ |
| 93 | CF | CF | CF | CSF₅ |
| 94 | CF | CH | CH | CSF₅ |
| 95 | CH | C-Aryl | CH | CH |
| 96 | CH | C-Aryl | CCF₃ | CH |
| 97 | CH | C-Aryl | CH | CCF₃ |
| 98 | CH | C-Aryl | CCF₃ | CCF₃ |
| 99 | CCF₃ | C-Aryl | CH | CH |
| 100 | CCF₃ | C-Aryl | CCF₃ | CH |
| 101 | CCF₃ | C-Aryl | CH | CCF₃ |
| 102 | CCF₃ | C-Aryl | CCF₃ | CCF₃ |
| 103 | CH | C-Aryl | C-Aryl | CH |
| 104 | CH | C-Aryl | C-Aryl | CCF₃ |
| 105 | CCF₃ | C-Aryl | C-Aryl | CH |
| 106 | CCF₃ | C-Aryl | C-Aryl | CCF₃ |
| 107 | CH | C-Aryl | C-Aryl | CF |
| 108 | CF | C-Aryl | C-Aryl | CH |
| 109 | CF | C-Aryl | C-Aryl | CF |
| 110 | CH | C-Aryl | C-Aryl | CSF₅ |
| 111 | CSF₅ | C-Aryl | C-Aryl | CH |
| 112 | CSF₅ | C-Aryl | C-Aryl | CSF₅ |
| 113 | CH | CSF₅ | CSF₅ | CCF₃ |
| 114 | CCF₃ | CSF₅ | CSF₅ | CH |
| 115 | CCF₃ | CSF₅ | CSF₅ | CCF₃ |
| 116 | CH | CSF₅ | CSF₅ | COCF₃ |
| 117 | COCF₃ | CSF₅ | CSF₅ | CH |
| 118 | COCF₃ | CSF₅ | CSF₅ | COCF₃ |
| 119 | N | CF | CH | CH |
| 120 | N | CF | CF | CH |
| 121 | N | CF | CH | CF |
| 122 | N | CF | CF | CF |
| 123 | N | CH | CH | CF |
| 124 | CH | N | CF | CH |
| 125 | CH | N | CH | CF |
| 126 | CH | N | CF | CF |
| 127 | CF | N | CH | CH |
| 128 | CF | N | CF | CH |
| 129 | CF | N | CH | CF |
| 130 | CF | N | CF | CF |
| 131 | CH | CF | CH | N |
| 132 | CH | CF | CF | N |
| 133 | CF | CF | CH | N |
| 134 | CF | CF | CF | N |
| 135 | CF | CH | CH | N |
| 136 | N | CF | CCF₃ | CCF₃ |
| 137 | N | CF | CF | CCF₃ |
| 138 | N | CF | CCF₃ | CF |
| 139 | N | CF | CF | CF |
| 140 | N | CCF₃ | CCF₃ | CF |
| 141 | CCF₃ | N | CF | CCF₃ |
| 142 | CCF₃ | N | CCF₃ | CF |
| 143 | CCF₃ | N | CF | CF |
| 144 | CF | N | CCF₃ | CCF₃ |
| 145 | CF | N | CF | CCF₃ |
| 146 | CF | N | CCF₃ | CF |
| 147 | CF | N | CF | CF |
| 148 | CCF₃ | CF | CCF₃ | N |
| 149 | CCF₃ | CF | CF | N |
| 150 | CF | CF | CCF₃ | N |
| 151 | CF | CF | CF | N |
| 152 | CF | CCF₃ | CCF₃ | N |
| 153 | CH | CSF₅ | CH | CH |
| 154 | CH | CSF₅ | CCF₃ | CH |
| 155 | CH | CSF₅ | CH | CCF₃ |
| 156 | CH | CSF₅ | CCF₃ | CCF₃ |
| 157 | CCF₃ | CSF₅ | CH | CH |
| 158 | CCF₃ | CSF₅ | CCF₃ | CH |
| 159 | CCF₃ | CSF₅ | CH | CCF₃ |
| 160 | CCF₃ | CSF₅ | CCF₃ | CCF₃ |
| 161 | CH | CSO₂CF₃ | CH | CH |
| 162 | CH | CSO₂CF₃ | CCF₃ | CH |
| 163 | CH | CSO₂CF₃ | CH | CCF₃ |
| 164 | CH | CSO₂CF₃ | CCF₃ | CCF₃ |
| 165 | CCF₃ | CSO₂CF₃ | CH | CH |
| 166 | CCF₃ | CSO₂CF₃ | CCF₃ | CH |
| 167 | CCF₃ | CSO₂CF₃ | CH | CCF₃ |
| 168 | CCF₃ | CSO₂CF₃ | CCF₃ | CCF₃ |

Preferred is a compound according to formula (I.b),

[Ce⁴⁺]₂L_{E}²⁻L_{F}²⁻L_{G}²⁻L_{H}²⁻ (I.b)

or their single reduced species or their twice reduced species or their charge transfer complexes with donors,
wherein L_{E}, L_{F}, L_{G} and L_{H} have the same meanings and are a bis-bidentateligand selected from formula (II.d), 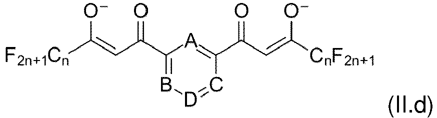 wherein n=3,
and A, B, C, and D are each selected from the definition given in one line of the following table 3.

**Table 3:**

| Entry | A= | B= | C= | D= |
|---|---|---|---|---|
| 1 | CH | CH | CH | CH |
| 2 | CH | CCF₃ | CH | CH |
| 3 | CH | CCF₃ | CCF₃ | CH |
| 4 | CH | CCF₃ | CH | CCF₃ |
| 5 | CH | CCF₃ | CCF₃ | CCF₃ |
| 6 | CH | CH | CH | CCF₃ |
| 7 | CCF₃ | CH | CH | CH |
| 8 | CCF₃ | CCF₃ | CH | CH |
| 9 | CCF₃ | CCF₃ | CCF₃ | CH |
| 10 | CCF₃ | CCF₃ | CH | CCF₃ |
| 11 | CCF₃ | CCF₃ | CCF₃ | CCF₃ |
| 12 | CCF₃ | CH | CH | CCF₃ |
| 13 | CH | CF | CH | CH |
| 14 | CH | CF | CF | CH |
| 15 | CH | CF | CH | CF |
| 16 | CH | CF | CF | CF |
| 17 | CH | CH | CH | CF |
| 18 | CF | CH | CH | CH |
| 19 | CF | CF | CH | CH |
| 20 | CF | CF | CF | CH |
| 21 | CF | CF | CH | CF |
| 22 | CF | CF | CF | CF |
| 23 | CF | CH | CH | CF |
| 24 | N | CH | CH | CH |
| 25 | N | CCF₃ | CH | CH |
| 26 | N | CCF₃ | CCF₃ | CH |
| 27 | N | CCF₃ | CH | CCF₃ |
| 28 | N | CCF₃ | CCF₃ | CCF₃ |
| 29 | N | CH | CH | CCF₃ |
| 30 | CH | N | CH | CH |
| 31 | CH | N | CCF₃ | CH |
| 32 | CH | N | CH | CCF₃ |
| 33 | CH | N | CCF₃ | CCF₃ |
| 34 | CCF₃ | N | CH | CH |
| 35 | CCF₃ | N | CCF₃ | CH |
| 36 | CCF₃ | N | CH | CCF₃ |
| 37 | CCF₃ | N | CCF₃ | CCF₃ |
| 38 | CH | CCF₃ | CH | N |
| 39 | CH | CCF₃ | CCF₃ | N |
| 40 | CH | CH | CH | N |
| 41 | CCF₃ | CCF₃ | CH | N |
| 42 | CCF₃ | CCF₃ | CCF₃ | N |
| 43 | CCF₃ | CH | CH | N |
| 44 | N | CH | CH | N |
| 45 | N | CCF₃ | CH | N |
| 46 | N | CCF₃ | CCF₃ | N |
| 47 | CH | CCF₃ | CH | C-Aryl |
| 48 | CH | CCF₃ | CCF₃ | C-Aryl |
| 49 | CH | CH | CH | C-Aryl |
| 50 | CCF₃ | CCF₃ | CH | C-Aryl |
| 51 | CCF₃ | CCF₃ | CCF₃ | C-Aryl |
| 52 | CCF₃ | CH | CH | C-Aryl |
| 53 | CH | N | N | CH |
| 54 | CH | N | N | CCF₃ |
| 55 | CCF₃ | N | N | CH |
| 56 | CCF₃ | N | N | CCF₃ |
| 57 | N | N | CH | CH |
| 58 | N | N | CCF₃ | CH |
| 59 | N | N | CH | CCF₃ |
| 60 | N | N | CCF₃ | CCF₃ |
| 61 | N | N | N | CH |
| 62 | N | N | N | CCF₃ |
| 63 | CF | CCF₃ | CF | CF |
| 64 | CF | CCF₃ | CCF₃ | CF |
| 65 | CF | CCF₃ | CF | CCF₃ |
| 66 | CF | CCF₃ | CCF₃ | CCF₃ |
| 67 | CF | CF | CF | CCF₃ |
| 68 | CCF₃ | CF | CF | CF |
| 69 | CCF₃ | CCF₃ | CF | CF |
| 70 | CCF₃ | CCF₃ | CCF₃ | CF |
| 71 | CCF₃ | CCF₃ | CF | CCF₃ |
| 72 | CCF₃ | CCF₃ | CCF₃ | CCF₃ |
| 73 | CCF₃ | CF | CF | CCF₃ |
| 74 | CH | CCF₃ | CF | CF |
| 75 | CH | CCF₃ | CCF₃ | CF |
| 76 | CH | CCF₃ | CF | CCF₃ |
| 77 | CH | CF | CH | COCF₃ |
| 78 | CH | CF | CF | COCF₃ |
| 79 | CH | CH | CH | COCF₃ |
| 80 | CF | CF | CH | COCF₃ |
| 81 | CF | CF | CF | COCF₃ |
| 82 | CF | CH | CH | COCF₃ |
| 83 | CH | CF | CH | CSO₂CF₃ |
| 84 | CH | CF | CF | CSO₂CF₃ |
| 85 | CH | CH | CH | CSO₂CF₃ |
| 86 | CF | CF | CH | CSO₂CF₃ |
| 87 | CF | CF | CF | CSO₂CF₃ |
| 88 | CF | CH | CH | CSO₂CF₃ |
| 89 | CH | CF | CH | CSF₅ |
| 90 | CH | CF | CF | CSF₅ |
| 91 | CH | CH | CH | CSF₅ |
| 92 | CF | CF | CH | CSF₅ |
| 93 | CF | CF | CF | CSF₅ |
| 94 | CF | CH | CH | CSF₅ |
| 95 | CH | C-Aryl | CH | CH |
| 96 | CH | C-Aryl | CCF₃ | CH |
| 97 | CH | C-Aryl | CH | CCF₃ |
| 98 | CH | C-Aryl | CCF₃ | CCF₃ |
| 99 | CCF₃ | C-Aryl | CH | CH |
| 100 | CCF₃ | C-Aryl | CCF₃ | CH |
| 101 | CCF₃ | C-Aryl | CH | CCF₃ |
| 102 | CCF₃ | C-Aryl | CCF₃ | CCF₃ |
| 103 | CH | C-Aryl | C-Aryl | CH |
| 104 | CH | C-Aryl | C-Aryl | CCF₃ |
| 105 | CCF₃ | C-Aryl | C-Aryl | CH |
| 106 | CCF₃ | C-Aryl | C-Aryl | CCF₃ |
| 107 | CH | C-Aryl | C-Aryl | CF |
| 108 | CF | C-Aryl | C-Aryl | CH |
| 109 | CF | C-Aryl | C-Aryl | CF |
| 110 | CH | C-Aryl | C-Aryl | CSF₅ |
| 111 | CSF₅ | C-Aryl | C-Aryl | CH |
| 112 | CSF₅ | C-Aryl | C-Aryl | CSF₅ |
| 113 | CH | CSF₅ | CSF₅ | CCF₃ |
| 114 | CCF₃ | CSF₅ | CSF₅ | CH |
| 115 | CCF₃ | CSF₅ | CSF₅ | CCF₃ |
| 116 | CH | CSF₅ | CSF₅ | COCF₃ |
| 117 | COCF₃ | CSF₅ | CSF₅ | CH |
| 118 | COCF₃ | CSF₅ | CSF₅ | COCF₃ |
| 119 | N | CF | CH | CH |
| 120 | N | CF | CF | CH |
| 121 | N | CF | CH | CF |
| 122 | N | CF | CF | CF |
| 123 | N | CH | CH | CF |
| 124 | CH | N | CF | CH |
| 125 | CH | N | CH | CF |
| 126 | CH | N | CF | CF |
| 127 | CF | N | CH | CH |
| 128 | CF | N | CF | CH |
| 129 | CF | N | CH | CF |
| 130 | CF | N | CF | CF |
| 131 | CH | CF | CH | N |
| 132 | CH | CF | CF | N |
| 133 | CF | CF | CH | N |
| 134 | CF | CF | CF | N |
| 135 | CF | CH | CH | N |
| 136 | N | CF | CCF₃ | CCF₃ |
| 137 | N | CF | CF | CCF₃ |
| 138 | N | CF | CCF₃ | CF |
| 139 | N | CF | CF | CF |
| 140 | N | CCF₃ | CCF₃ | CF |
| 141 | CCF₃ | N | CF | CCF₃ |
| 142 | CCF₃ | N | CCF₃ | CF |
| 143 | CCF₃ | N | CF | CF |
| 144 | CF | N | CCF₃ | CCF₃ |
| 145 | CF | N | CF | CCF₃ |
| 146 | CF | N | CCF₃ | CF |
| 147 | CF | N | CF | CF |
| 148 | CCF₃ | CF | CCF₃ | N |
| 149 | CCF₃ | CF | CF | N |
| 150 | CF | CF | CCF₃ | N |
| 151 | CF | CF | CF | N |
| 152 | CF | CCF₃ | CCF₃ | N |
| 153 | CH | CSF₅ | CH | CH |
| 154 | CH | CSF₅ | CCF₃ | CH |
| 155 | CH | CSF₅ | CH | CCF₃ |
| 156 | CH | CSF₅ | CCF₃ | CCF₃ |
| 157 | CCF₃ | CSF₅ | CH | CH |
| 158 | CCF₃ | CSF₅ | CCF₃ | CH |
| 159 | CCF₃ | CSF₅ | CH | CCF₃ |
| 160 | CCF₃ | CSF₅ | CCF₃ | CCF₃ |
| 161 | CH | CSO₂CF₃ | CH | CH |
| 162 | CH | CSO₂CF₃ | CCF₃ | CH |
| 163 | CH | CSO₂CF₃ | CH | CCF₃ |
| 164 | CH | CSO₂CF₃ | CCF₃ | CCF₃ |
| 165 | CCF₃ | CSO₂CF₃ | CH | CH |
| 166 | CCF₃ | CSO₂CF₃ | CCF₃ | CH |
| 167 | CCF₃ | CSO₂CF₃ | CH | CCF₃ |
| 168 | CCF₃ | CSO₂CF₃ | CCF₃ | CCF₃ |

Preferred is a compound according to formula (I.b),

[Ce⁴⁺]₂L_{E}²⁻L_{F}²⁻L_{G}²⁻L_{H}²⁻ (I.b)

or their single reduced species or their twice reduced species or their charge transfer complexes with donors,
wherein L_{E}, L_{F}, L_{G} and L_{H} have the same meanings and are a bis-bidentateligand selected from formula (Il.d), 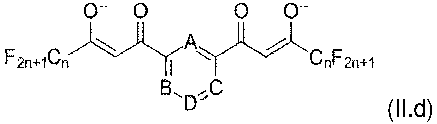 wherein n=4,
and A, B, C, and D are each selected from the definition given in one line of the following table 4.

**Table 4:**

| Entry | A= | B= | C= | D= |
|---|---|---|---|---|
| 1 | CH | CH | CH | CH |
| 2 | CH | CCF₃ | CH | CH |
| 3 | CH | CCF₃ | CCF₃ | CH |
| 4 | CH | CCF₃ | CH | CCF₃ |
| 5 | CH | CCF₃ | CCF₃ | CCF₃ |
| 6 | CH | CH | CH | CCF₃ |
| 7 | CCF₃ | CH | CH | CH |
| 8 | CCF₃ | CCF₃ | CH | CH |
| 9 | CCF₃ | CCF₃ | CCF₃ | CH |
| 10 | CCF₃ | CCF₃ | CH | CCF₃ |
| 11 | CCF₃ | CCF₃ | CCF₃ | CCF₃ |
| 12 | CCF₃ | CH | CH | CCF₃ |
| 13 | CH | CF | CH | CH |
| 14 | CH | CF | CF | CH |
| 15 | CH | CF | CH | CF |
| 16 | CH | CF | CF | CF |
| 17 | CH | CH | CH | CF |
| 18 | CF | CH | CH | CH |
| 19 | CF | CF | CH | CH |
| 20 | CF | CF | CF | CH |
| 21 | CF | CF | CH | CF |
| 22 | CF | CF | CF | CF |
| 23 | CF | CH | CH | CF |
| 24 | N | CH | CH | CH |
| 25 | N | CCF₃ | CH | CH |
| 26 | N | CCF₃ | CCF₃ | CH |
| 27 | N | CCF₃ | CH | CCF₃ |
| 28 | N | CCF₃ | CCF₃ | CCF₃ |
| 29 | N | CH | CH | CCF₃ |
| 30 | CH | N | CH | CH |
| 31 | CH | N | CCF₃ | CH |
| 32 | CH | N | CH | CCF₃ |
| 33 | CH | N | CCF₃ | CCF₃ |
| 34 | CCF₃ | N | CH | CH |
| 35 | CCF₃ | N | CCF₃ | CH |
| 36 | CCF₃ | N | CH | CCF₃ |
| 37 | CCF₃ | N | CCF₃ | CCF₃ |
| 38 | CH | CCF₃ | CH | N |
| 39 | CH | CCF₃ | CCF₃ | N |
| 40 | CH | CH | CH | N |
| 41 | CCF₃ | CCF₃ | CH | N |
| 42 | CCF₃ | CCF₃ | CCF₃ | N |
| 43 | CCF₃ | CH | CH | N |
| 44 | N | CH | CH | N |
| 45 | N | CCF₃ | CH | N |
| 46 | N | CCF₃ | CCF₃ | N |
| 47 | CH | CCF₃ | CH | C-Aryl |
| 48 | CH | CCF₃ | CCF₃ | C-Aryl |
| 49 | CH | CH | CH | C-Aryl |
| 50 | CCF₃ | CCF₃ | CH | C-Aryl |
| 51 | CCF₃ | CCF₃ | CCF₃ | C-Aryl |
| 52 | CCF₃ | CH | CH | C-Aryl |
| 53 | CH | N | N | CH |
| 54 | CH | N | N | CCF₃ |
| 55 | CCF₃ | N | N | CH |
| 56 | CCF₃ | N | N | CCF₃ |
| 57 | N | N | CH | CH |
| 58 | N | N | CCF₃ | CH |
| 59 | N | N | CH | CCF₃ |
| 60 | N | N | CCF₃ | CCF₃ |
| 61 | N | N | N | CH |
| 62 | N | N | N | CCF₃ |
| 63 | CF | CCF₃ | CF | CF |
| 64 | CF | CCF₃ | CCF₃ | CF |
| 65 | CF | CCF₃ | CF | CCF₃ |
| 66 | CF | CCF₃ | CCF₃ | CCF₃ |
| 67 | CF | CF | CF | CCF₃ |
| 68 | CCF₃ | CF | CF | CF |
| 69 | CCF₃ | CCF₃ | CF | CF |
| 70 | CCF₃ | CCF₃ | CCF₃ | CF |
| 71 | CCF₃ | CCF₃ | CF | CCF₃ |
| 72 | CCF₃ | CCF₃ | CCF₃ | CCF₃ |
| 73 | CCF₃ | CF | CF | CCF₃ |
| 74 | CH | CCF₃ | CF | CF |
| 75 | CH | CCF₃ | CCF₃ | CF |
| 76 | CH | CCF₃ | CF | CCF₃ |
| 77 | CH | CF | CH | COCF₃ |
| 78 | CH | CF | CF | COCF₃ |
| 79 | CH | CH | CH | COCF₃ |
| 80 | CF | CF | CH | COCF₃ |
| 81 | CF | CF | CF | COCF₃ |
| 82 | CF | CH | CH | COCF₃ |
| 83 | CH | CF | CH | CSO₂CF₃ |
| 84 | CH | CF | CF | CSO₂CF₃ |
| 85 | CH | CH | CH | CSO₂CF₃ |
| 86 | CF | CF | CH | CSO₂CF₃ |
| 87 | CF | CF | CF | CSO₂CF₃ |
| 88 | CF | CH | CH | CSO₂CF₃ |
| 89 | CH | CF | CH | CSF₅ |
| 90 | CH | CF | CF | CSF₅ |
| 91 | CH | CH | CH | CSF₅ |
| 92 | CF | CF | CH | CSF₅ |
| 93 | CF | CF | CF | CSF₅ |
| 94 | CF | CH | CH | CSF₅ |
| 95 | CH | C-Aryl | CH | CH |
| 96 | CH | C-Aryl | CCF₃ | CH |
| 97 | CH | C-Aryl | CH | CCF₃ |
| 98 | CH | C-Aryl | CCF₃ | CCF₃ |
| 99 | CCF₃ | C-Aryl | CH | CH |
| 100 | CCF₃ | C-Aryl | CCF₃ | CH |
| 101 | CCF₃ | C-Aryl | CH | CCF₃ |
| 102 | CCF₃ | C-Aryl | CCF₃ | CCF₃ |
| 103 | CH | C-Aryl | C-Aryl | CH |
| 104 | CH | C-Aryl | C-Aryl | CCF₃ |
| 105 | CCF₃ | C-Aryl | C-Aryl | CH |
| 106 | CCF₃ | C-Aryl | C-Aryl | CCF₃ |
| 107 | CH | C-Aryl | C-Aryl | CF |
| 108 | CF | C-Aryl | C-Aryl | CH |
| 109 | CF | C-Aryl | C-Aryl | CF |
| 110 | CH | C-Aryl | C-Aryl | CSF₅ |
| 111 | CSF₅ | C-Aryl | C-Aryl | CH |
| 112 | CSF₅ | C-Aryl | C-Aryl | CSF₅ |
| 113 | CH | CSF₅ | CSF₅ | CCF₃ |
| 114 | CCF₃ | CSF₅ | CSF₅ | CH |
| 115 | CCF₃ | CSF₅ | CSF₅ | CCF₃ |
| 116 | CH | CSF₅ | CSF₅ | COCF₃ |
| 117 | COCF₃ | CSF₅ | CSF₅ | CH |
| 118 | COCF₃ | CSF₅ | CSF₅ | COCF₃ |
| 119 | N | CF | CH | CH |
| 120 | N | CF | CF | CH |
| 121 | N | CF | CH | CF |
| 122 | N | CF | CF | CF |
| 123 | N | CH | CH | CF |
| 124 | CH | N | CF | CH |
| 125 | CH | N | CH | CF |
| 126 | CH | N | CF | CF |
| 127 | CF | N | CH | CH |
| 128 | CF | N | CF | CH |
| 129 | CF | N | CH | CF |
| 130 | CF | N | CF | CF |
| 131 | CH | CF | CH | N |
| 132 | CH | CF | CF | N |
| 133 | CF | CF | CH | N |
| 134 | CF | CF | CF | N |
| 135 | CF | CH | CH | N |
| 136 | N | CF | CCF₃ | CCF₃ |
| 137 | N | CF | CF | CCF₃ |
| 138 | N | CF | CCF₃ | CF |
| 139 | N | CF | CF | CF |
| 140 | N | CCF₃ | CCF₃ | CF |
| 141 | CCF₃ | N | CF | CCF₃ |
| 142 | CCF₃ | N | CCF₃ | CF |
| 143 | CCF₃ | N | CF | CF |
| 144 | CF | N | CCF₃ | CCF₃ |
| 145 | CF | N | CF | CCF₃ |
| 146 | CF | N | CCF₃ | CF |
| 147 | CF | N | CF | CF |
| 148 | CCF₃ | CF | CCF₃ | N |
| 149 | CCF₃ | CF | CF | N |
| 150 | CF | CF | CCF₃ | N |
| 151 | CF | CF | CF | N |
| 152 | CF | CCF₃ | CCF₃ | N |
| 153 | CH | CSF₅ | CH | CH |
| 154 | CH | CSF₅ | CCF₃ | CH |
| 155 | CH | CSF₅ | CH | CCF₃ |
| 156 | CH | CSF₅ | CCF₃ | CCF₃ |
| 157 | CCF₃ | CSF₅ | CH | CH |
| 158 | CCF₃ | CSF₅ | CCF₃ | CH |
| 159 | CCF₃ | CSF₅ | CH | CCF₃ |
| 160 | CCF₃ | CSF₅ | CCF₃ | CCF₃ |
| 161 | CH | CSO₂CF₃ | CH | CH |
| 162 | CH | CSO₂CF₃ | CCF₃ | CH |
| 163 | CH | CSO₂CF₃ | CH | CCF₃ |
| 164 | CH | CSO₂CF₃ | CCF₃ | CCF₃ |
| 165 | CCF₃ | CSO₂CF₃ | CH | CH |
| 166 | CCF₃ | CSO₂CF₃ | CCF₃ | CH |
| 167 | CCF₃ | CSO₂CF₃ | CH | CCF₃ |
| 168 | CCF₃ | CSO₂CF₃ | CCF₃ | CCF₃ |

### Table with preferred compounds:

Preferred is a compound according to formula (I.b),

[Ce⁴⁺]₂L_{E}²⁻L_{F}²⁻L_{G}²-L_{H}²- (I.b)

or their single reduced species or their twice reduced species or their charge transfer complexes with donors,
wherein L_{E}, L_{F}, L_{G} and L_{H} have the same meanings and are a bis-bidentate ligand selected from formula (ll.e), 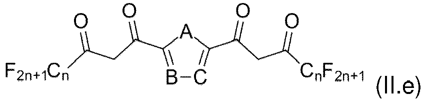 wherein n=1,
and A, B, and C are each selected from the definition given in one line of the following table 5.

**Table 5:**

| Entry | A= | B= | C= |
|---|---|---|---|
| 1 | S | CH | CH |
| 2 | S | CCF₃ | CH |
| 3 | S | CCF₃ | CCF₃ |
| 4 | NH | CH | CH |
| 5 | NH | CCF₃ | CH |
| 6 | NH | CCF₃ | CCF₃ |
| 7 | O | CH | CH |
| 8 | O | CCF₃ | CH |
| 9 | O | CCF₃ | CCF₃ |
| 10 | NH | N | CH |
| 11 | O | N | CH |
| 12 | S | N | CH |
| 13 | NH | N | CF |
| 14 | O | N | CF |
| 15 | S | N | CF |
| 16 | NH | N | CCF₃ |
| 17 | O | N | CCF₃ |
| 18 | S | N | CCF₃ |
| 19 | NH | N | CSF₅ |
| 20 | O | N | CSF₅ |
| 21 | S | N | CSF₅ |
| 22 | NH | N | C-Aryl |
| 23 | O | N | C-Aryl |
| 24 | S | N | C-Aryl |
| 25 | S | CF | CH |
| 26 | S | CF | CF |
| 27 | NH | CF | CH |
| 28 | NH | CF | CF |
| 29 | O | CF | CH |
| 30 | O | CF | CF |

Preferred is a compound according to formula (I.b),

[Ce⁴⁺]₂L_{E}²⁻L_{F}²⁻L_{G}²⁻L_{H}²⁻ (I.b)

or their single reduced species or their twice reduced species or their charge transfer complexes with donors,
wherein L_{E}, L_{F}, L_{G} and L_{H} have the same meanings and are a bis-bidentate ligand selected from formula (II.e), 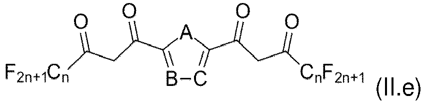 wherein n=2,
and A, B, and C are each selected from the definition given in one line of the following table 6.

**Table 6:**

| Entry | A= | B= | C= |
|---|---|---|---|
| 1 | S | CH | CH |
| 2 | S | CCF₃ | CH |
| 3 | S | CCF₃ | CCF₃ |
| 4 | NH | CH | CH |
| 5 | NH | CCF₃ | CH |
| 6 | NH | CCF₃ | CCF₃ |
| 7 | O | CH | CH |
| 8 | O | CCF₃ | CH |
| 9 | O | CCF₃ | CCF₃ |
| 10 | NH | N | CH |
| 11 | O | N | CH |
| 12 | S | N | CH |
| 13 | NH | N | CF |
| 14 | O | N | CF |
| 15 | S | N | CF |
| 16 | NH | N | CCF₃ |
| 17 | O | N | CCF₃ |
| 18 | S | N | CCF₃ |
| 19 | NH | N | CSF₅ |
| 20 | O | N | CSF₅ |
| 21 | S | N | CSF₅ |
| 22 | NH | N | C-Aryl |
| 23 | O | N | C-Aryl |
| 24 | S | N | C-Aryl |
| 25 | S | CF | CH |
| 26 | S | CF | CF |
| 27 | NH | CF | CH |
| 28 | NH | CF | CF |
| 29 | O | CF | CH |
| 30 | O | CF | CF |

Preferred is a compound according to formula (I.b),

[Ce⁴⁺][₂L_{E}²⁻L_{F}²⁻L_{G}²⁻L_{H}²⁻ (I.b)

or their single reduced species or their twice reduced species or their charge transfer complexes with donors,
wherein L_{E}, L_{F}, L_{G} and L_{H} have the same meanings and are a bis-bidentate ligand selected from formula (II.e), 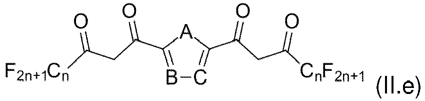 wherein n=3,
and A, B, and C are each selected from the definition given in one line of the following table 7.

**Table 7:**

| Entry | A= | B= | C= |
|---|---|---|---|
| 1 | S | CH | CH |
| 2 | S | CCF₃ | CH |
| 3 | S | CCF₃ | CCF₃ |
| 4 | NH | CH | CH |
| 5 | NH | CCF₃ | CH |
| 6 | NH | CCF₃ | CCF₃ |
| 7 | O | CH | CH |
| 8 | O | CCF₃ | CH |
| 9 | O | CCF₃ | CCF₃ |
| 10 | NH | N | CH |
| 11 | O | N | CH |
| 12 | S | N | CH |
| 13 | NH | N | CF |
| 14 | O | N | CF |
| 15 | S | N | CF |
| 16 | NH | N | CCF₃ |
| 17 | O | N | CCF₃ |
| 18 | S | N | CCF₃ |
| 19 | NH | N | CSF₅ |
| 20 | O | N | CSF₅ |
| 21 | S | N | CSF₅ |
| 22 | NH | N | C-Aryl |
| 23 | O | N | C-Aryl |
| 24 | S | N | C-Aryl |
| 25 | S | CF | CH |
| 26 | S | CF | CF |
| 27 | NH | CF | CH |
| 28 | NH | CF | CF |
| 29 | O | CF | CH |
| 30 | O | CF | CF |

Preferred is a compound according to formula (I.b),

[Ce⁴⁺]₂L_{E}²⁻L_{F}²⁻L_{G}²⁻L_{H}²⁻ (I.b)

or their single reduced species or their twice reduced species or their charge transfer complexes with donors,
wherein L_{E}, L_{F}, L_{G} and L_{H} have the same meanings and are a bis-bidentate ligand selected from formula

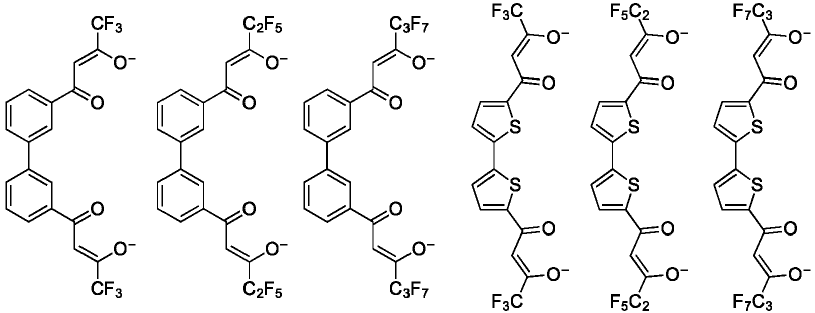

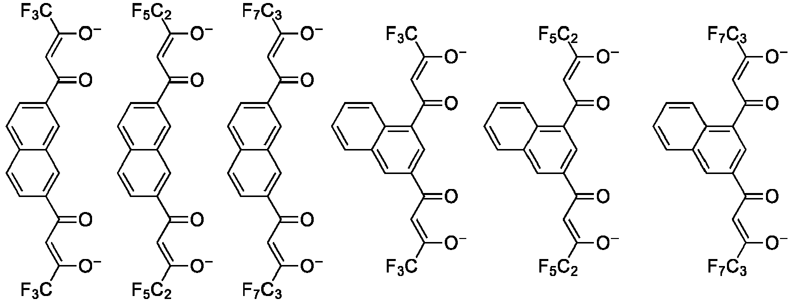

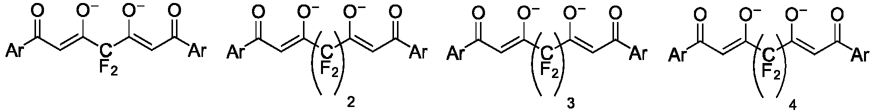

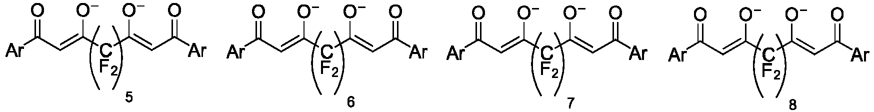

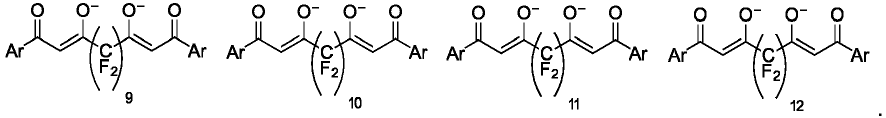

### ELECTRONIC COMPONENT

In the context of the invention, an electronic component is understood to be a discrete or integrated electrical component that utilizes the properties of compounds of the general formula (I) and/or formula (I.a) or semiconductor layers that contain a compound of the general formula (I) and/or formula (I.a).

In the context of the present specification the term "compound of the general formula (I)" means a compound that corresponds to the formula (I) according to the invention as defined herein. An electronic component which comprises a compound of the general formula (I) may comprise each compound which is included in one of the preferred embodiments of the compounds as described herein. This also applies to the term "compound of the formula (I)".

In the context of the present specification the term "compound of the general formula (I.a)" means a compound that corresponds to the formula (I.a) according to the invention as defined herein. An electronic component which comprises a compound of the general formula (I.a) may comprise each compound which is included in one of the preferred embodiments of the compounds as described herein. This also applies to the term "compound of the formula (I.a)".

All specifications for the compounds and preferred embodiments of the compounds apply analogously to the electronic component.

In a particular embodiment, the electronic component has a layered structure comprising 2 to 50 layers, preferably 3 to 30 layers, more preferably 5 to 20 layers, wherein at least one of the layers comprises at least one compound of general formula (I) and/or formula (La). However, each of the layers may also comprise inorganic materials, or the component may also comprise layers composed entirely of inorganic materials.

Preferably, the electronic component is selected from
- a light-emitting device, preferably a light-emitting electrochemical cell or an organic electroluminescent device, more preferably an organic light-emitting diode (OLED), especially a triple-stack organic light-emitting diode, or a quadrupole-stack organic light-emitting diode,
- a display device,
- a photovoltaic cell, preferably an organic solar cell, preferably a single-stack organic solar cell, a tandem-stack organic solar cell, a triple-stack organic soIar cell, a quadrupole-stack organic solar cell, a Perovskite solar cell, or a dye sensitized solar cell,
- an organic photodetector,
- an organic transistor, preferably organic thin-film transistors (OTFTs),
- an organic diode,
- an organic laser diode,
- devices for electrophotography, or
a battery.

Preferably, the matrix material for the hole transport layer is selected from
- A fully or partially substituted triaryl amine and its derivatives
- A fully or partially substituted carbazol derivative
- A hole transport material that has for example a HOMO-level of less than -4.8 eV measured with cyclic voltammetry as described herein
- A hole transport material that has for example a HOMO-level higher than -6.0 eV measured with cyclic voltammetry as described herein
- A hole transport material that has a HOMO-level deeper than or equal to the HOMO-level of BPAPF, i.e. a HOMO-level deeper than the HOMO-level of BPAPF, when measured with the same method
- A hole transport material that has partially or fully substituted thiophene units or is an oligo- or polythiophene
- A hole transport material that consists of partially or fully substituted aryl or heteroaryl rings, but does not contain any triarylamine functional units
- A hole transport material that includes substituted carbazole units
- A semiconductor matrix material selected according to EP3859808

More preferably, the electronic component according to the invention is in the form of an organic light-emitting diode, an organic solar cell, a perovskite solar cell, an organic photodiode or an organic thin-film transistor.

In a preferred embodiment the electronic component according to the invention comprises at least one hole transport layer and/or at least one hole injection layer and/or at least one hole extraction layer, which comprises at least one or more of the compounds of formula (I) and/or formula (I.a). The compound of formula (I) and/or formula (I.a) comprised in the hole transport layer may be the same or different from the compound of formula (I) and/or formula (I.a) in the hole injection or extraction layer.

Generally, a hole injection layer is a layer which facilitates hole injection from the anode into the semiconductor matrix material. The hole injection layer can be placed directly adjacent to the anode. A hole transport layer transports the holes from the anode to the emitting layer and is located between a hole injection layer and an emitting layer.

The hole injection layer may be composed of a first sub-layer comprising a compound of formula (I) and/or formula (I.a) and a second sub-layer comprising a semiconductor matrix material, wherein the first sub-layer is closer to the anode and the second sub-layer is closer to the emitting layer. The first sub-layer may also consist of a compound of formula (I) and/or formula (I.a). The second sub-layer may or may not comprise a compound of formula (I) and/or formula (I.a) in addition to a semiconductor matrix material.

The hole-injection layer and/or hole-transport layer in an electronic component according to the invention may also comprise a second p-dopant different from compounds of formula (I) and/or formula (I.a), for example each of the layers may also comprise doping materials selected from the following list (I).

### List (I):

The class of 3-radialenes, preferrably α,α',α"-1,2,3-Cyclopropanetriylidenetris[4-cyano-2,3,5,6-tetrafluorobenzeneacetonitrile], from the class of dicyanochinodimethane-derivatives, preferrably 2,3,5,6-Tetrafluor-7,7,8,8-tetracyanochindimethan, 2,2'-(1,3,4,5,7,8-Hexafluoro-2,6-naphthalenediylidene)bis[propanedinitrile], 2,2'-[4,8-Bis[2,4-bis(trifluoromethyl)phenyl]benzo[1,2-d:4,5-d']bisoxazole-2,6-diylidene]bis[propanedinitrile], from the class of metal complexes, in particular cerium(IV) diketonates and derivatives or from the class of benzobisoxazole and derivatives such as 2,2'-[4,8-Bis[2,4-bis(trifluoromethyl)phenyl]benzo[1,2-d:4,5-d']bisoxazole-2,6-diylidene]bis[propanedinitrile].

The second p-dopant may be present in the same or a different layer or sub-layer than the compound of formula (I), preferably of formula (I.a), preferably the compounds listed in the tables 1 to 7.

Preferably, the electronic component also comprises a substrate (a metal, glass, or plastic substrate), an anode layer with or without sublayers, and a cathode layer. More preferably, the electronic component also comprises at least one photoactive layer. The at least one photoactive layer may be a light-emitting layer or a light-absorbing layer.

The **anode layer** may be composed of a metal or a transparent conductive oxide. The anode layer may comprise a first and a second sub-layer, wherein the first sub-layer comprises a metal, and the second sub-layer comprises a transparent conductive oxide, and the second sub-layer is closer to the hole injection layer.

In a preferred embodiment, the electronic component comprises an electrode, in particular an anode, which comprises at least two sublayers. A first sublayer is preferably positioned between the substate and a second sublayer and the first sublayer comprises a metal with a work function between 3 eV and 7 eV, preferably between 4 eV and 6 eV. The second sublayer may comprise a transparent material, in particular a tranparent conductive oxide, e.g. indium tin oxide. Accordingly, the energy level alignment can be enhanced.

In a preferred embodiment an electronic component according to the invention, comprises at least one pn-junction, which comprises at least one or more of the compounds of formula (I) and/or formula (I.a). The pn-junction may be a charge-generation layer, for example connecting two light-emitting units. The pn-junction may also be a charge conversion contact or recombination contact, for example connecting two light-absorbing units. The pn-junction may also be used to connect an anode or a cathode to a light-emitting unit or an absorbing unit.

The electronic component may specifically be an organic electroluminescent device, particularly in the form of an organic light-emitting diode (OLED). An organic electroluminescent device comprises a cathode, an anode and at least one emitting layer. It may also include other layers in addition to these layers, for example, one or more each of hole injection layers, hole transport layers, hole blocking layers, electron transport layers, electron injection layers, electron blocking layers, exciton blocking layers, charge conversion contacts and/or charge generation layers, both also referred to as pn-junctions. Not each of these layers must necessarily be present.

In a preferred embodiment, an electronic component, particularly in the form of an OLED, the layer comprising at least one of the compounds of formula (I) and/or formula (I.a) is a **hole injection layer.** A hole injection layer is generally a layer that facilitates hole injection from the anode into the organic semiconductor layer. The hole injection layer can be placed directly adjacent to the anode. The anode may or may not be composed of several sublayers. The hole injection layer may be purely composed of a compound of formula (I) and/or formula (I.a). Preferably, the hole injection layer is composed of a semiconductor matrix material and one or more compound(s) of formula (I) and/or formula (I.a). The electronic component may also, in addition, include a pn-junction or a charge-generation layer, which comprises a p-dopant different from compounds of formula (I) and/or formula (I.a), e.g. selected from list (I).

In a preferred embodiment, an electronic component, particularly in the form of an OLED, the layer comprising at least one of the compounds of formula (I) and/or formula (I.a) is a **hole transport layer.** Preferably, the hole transport layer is composed of a semiconductor matrix material and one or more compound(s) of formula (I) and/or formula (I.a). Specifically, the hole transport layer may be located between a hole injection layer and an emitting layer, where it transports holes from the anode to the emitting layer. Between the hole transport layer and the emitting layer may be other layers, such as electron blocking layers, exciton blocking layers, and prime layers. In another embodiment, the hole transport layer is located between an electrode and an emission layer, where it transports holes from the electrode to the emission layer.

In another embodiment, preferably a tandem- or triple-stack OLED, the hole transport layer transports holes from a charge generation layer to an emitting layer. Between the hole transport layer and the emitting layer may be other layers, such as electron blocking layers, exciton blocking layers, and prime layers. The electronic component may also, in addition, include a hole-injection layer, which comprises a p-dopant different from compounds of formula (I) and/or formula (I.a) , e.g. selected from list (I). The electronic component may also, in addition, include a pn-junction or charge-generation layer, which comprises a p-dopant different from compounds of formula (I) and/or formula (I.a), e.g. selected from list (I).

In a preferred embodiment, an electronic component, particularly in the form of a **tandem or triple or quadruple-stack OLED,** the layer comprising the compound of formula (I) and/or formula (I.a) is part of a pn-junction, particularly in form of a charge-generation layer. The pn-junction may be composed of a hole-transport layer, an electron-transport layer, and optionally one or more interlayers. Preferably, the layer comprising a compound of formula (I) and/or formula (I.a) is the hole-transport layer. Preferably, this hole transport layer is composed of a semiconductor matrix material and one or more compound(s) of formula (I) and/or formula (I.a). A compound of formula (I) and/or formula (I.a) may also be used in an interlayer. The electronic component may also, in addition, include a hole injection and/or hole-transport layer, which comprises a p-dopant different from compounds of formula (I) and/or formula (I.a), e.g. selected from list (I).

A preferred embodiment is an electronic component in the form of an **organic solar cell.** Organic solar cells generally have a layered structure and typically include at least the following layers: anode, at least one photoactive layer and cathode. The photoactive region of the solar cell may comprise two layers, each having a homogeneous composition and forming a planar donor-acceptor heterojunction. A photoactive region may also comprise a mixed layer and form a donor-acceptor heterojunction in the form of a donor-acceptor bulk heterojunction. In addition to these layers, the organic solar cell may also comprise other layers, e.g., selected from electron extraction layer, hole extraction layer, electron transport layer (ETL), hole transport layers (HTL), exciton blocking layer, hole blocking layer, electron blocking layers, charge conversion layer, also referred to as charge recombination layer, optical spacers, and multiplier layers. Preferably, these layers do not absorb UV-visible light.

A preferred embodiment is an electronic component, particularly in the form of an organic solar cell, wherein the layer comprising at least one of the compounds of formula (I) and/or formula (I.a) is a **hole extraction layer.** Preferably, this hole extraction layer is composed of a semiconductor matrix material and one or more compound(s) of formula (I) and/or formula (I.a). The hole extraction layer may be placed directly adjacent to the anode. The electronic component may also, in addition, include a pn-junction or charge-conversion layer, which comprises a p-dopant different from compounds of formula (I) and/or formula (I.a), e.g. selected from list (I).

A preferred embodiment is an electronic component, particularly in the form of an organic solar cell, wherein the layer comprising at least one of the compounds of formula (I) and/or formula (I.a) is a **hole transport layer.** Preferably, this hole transport layer is composed of a semiconductor matrix material and one or more compound(s) of formula (I) and/or formula (I.a). The hole transport layer may be placed between a photoactive layer and an anode or between a photoactive layer and a charge conversion layer or a charge recombination layer. The electronic component may also, in addition, include a pn-junction or charge-generation layer, which comprises a p-dopant different from compounds of formula (I) and/or formula (I.a), e.g. selected from list (I).

Preferably, the electronic component according to the invention is in the form of an organic solar cell, particularly in the form of a **single, tandem, triple or quadruple-stack** organic solar cell, wherein the layer comprising at least one of the compounds of formula (I) and/or formula (I.a) is a pn-junction. The pn-junction may be a charge conversion or recombination contact, connecting a light-absorbing unit to an additional light-absorbing unit in a multi-stack device and/or a pn-junction (or conversion contact) connecting a cathode or an anode to a light-absorbing unit in a single or multi-stack device. The electronic component may also, in addition, include a hole extraction and/or hole transport layer, which comprises a p-dopant different from compounds of formula (I) and/or formula (I.a), e.g. selected from list (I).

Preferably, the electronic component according to the invention is in the form of an organic or hybrid solar cell, which are exciton solar cells, dye sensitized solar cells (DSSCs) or perovskite solar cells. Preferred devices for electrophotography are photoconductive materials in organic photoconductors (OPCs).

Preferred are electronic components comprising at least one compound of the formula (I), or formula (I.a) or one of the compounds listed in table 1, 2, 3, 4, 5, 6 or 7.

Inparticular, preferred are electronic components comprising at least one compound of the formula (I)

[Ce⁴⁺]₂[(L)ₙ]⁸⁻ (I),

wherein n is an integer from 1 to 8,
wherein L is independently of each other a ligand with at least five carbon atoms,
wherein L is similar or at least one L differs from the other L.

A ligand containing five carbon atoms is for example hexafluoroacetylacetonate.

The compound of formula (I) is preferably electronically neutral, i.e. the compound of formula (I) is electrically non-charged.

In one embodiment, n is selected from 2, 4, 8. As an advantage, the synthesis of these materials is simple.

In one embodiment, n is 2 or n is 4. As an advantage, the synthesis of these materials is even more simple.

In one embodiment, n is 4 and L is a bis-bidentate ligand.

In one embodiment, n is 2 and L is a bis-tetradentate ligand.

Preferred is the **electronic component** according to the invention, wherein n is 4 and L is a bis-bidentate ligand, and wherein the electronic component comprises at least one compound of the formula (I.a):

[Ce⁴⁺]₂L_{A}²⁻L_{B}²⁻L_{C}²⁻L_{D}²⁻ (I.a)

or their reduced species or their twice reduced species or their charge transfer complexes with donors, wherein L_{A},L_{B},L_{C},L_{D} have the same or different meanings, wherein L_{A}, L_{B}, L_{C} and L_{D} are each a bis-bidentate ligand independently selected from formula (II.a) 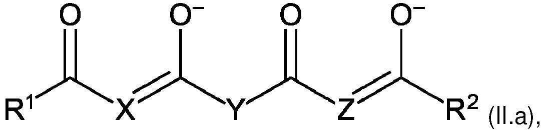 wherein
**X** is selected from C-H, C-CF₃ and C-R³;
**Z** is selected from C-H, C-CF₃ and C-R⁴,
**R¹, R²** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkylor C₁-C₆-haloalkyl,
   wherein aryl and heteroaryl are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyl, or C₆-C₁₄-aryl, which is unsubstituted or substituted by 1, 2 or 3 identical or
   different radicals selected from F, CN, C₁-C₄-alkyl and C₁-C₄-haloalkyl;
**R³ R⁴** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl or C₁-C₆-haloalkyl'
   wherein aryl and heteroaryl are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl
wherein
   **Y** is selected from C₆-C₁₄-arylene, 4- to 14-membered heteroarylene having 1, 2 or 3 identical or different heteroatoms or heteroatom-containing groups as ring members, selected from N, O, S, SO and SO₂, C₁-C₁₀-alkylene, C₃-C₆-cycloalkylene, C₃-C₆-cycloalkenylene, C₁-C₁₀-haloalkylene, C₁-C₁₀-haloalkylarylene, S, S-O, O, P-**R⁶,** P-O-R⁷, Si-(R⁸)₂, B-R⁹ and N-R¹⁰;
   wherein arylene and heteroarylene are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkylene, C₁-C₄-haloalkylene, or C₆-C₁₄-arylene, which is unsubstituted or substituted by 1, 2 or 3 identical or different radicals selected from F, CN, C₁-C₄-alkyl and C₁-C₄-haloalkyl;
   wherein **R⁶** is selected from C₁-C₄-alkyl, C₁-C₄-haloalkyland C₆-C₁₄-aryl, which is unsubstituted or substituted by 1, 2 or 3 identical or different radicals selected from F, CN, C₁-C₄-alkyl and C₁-C₄-haloalky;
   wherein **R⁷** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
   wherein **R⁸** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkylene;
   wherein **R⁹** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
   wherein **R¹⁰** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkylene.

Preferred is the **electronic component** according to the invention, wherein n is 4 and L is a bis-bidentate ligand, and wherein the electronic component comprises at least one compound of the formula (I.a):

[Ce⁴⁺]₂L_{A}²⁻L_{B}²⁻L_{C}²⁻L_{D}²⁻ (I.a)

or their reduced species or their twice reduced species or their charge transfer complexes with donors, wherein L_{A},L_{B},L_{C},L_{D} have the same or different meanings, wherein L_{A}, L_{B}, L_{C} and L_{D} are each a bis-bidentate ligand independently selected from formula (II.a) 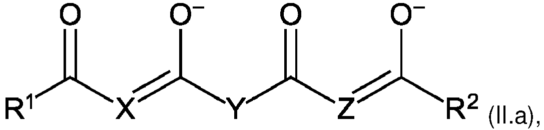 wherein
**X** is selected from C-H, C-CF₃ and C-R³;
**Z** is selected from C-H, C-CF₃ and C-R⁴;
**R¹, R²** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl or C₁-C₆-haloalkyl,
   wherein aryl and heteroaryl are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyl, or C₆-C₁₄-aryl, which is unsubstituted or substituted by 1, 2 or 3 identical or different radicals selected from F, CN, C₁-C₄-alkyl and C₁-C₄-haloalkyl,
**R³ R⁴** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl, C₁-C₆-haloalkyl;
   wherein aryl and heteroaryl are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkyl, C₁-C₄-haloalkyl, or C₆-C₁₄-aryl, which is unsubstituted or substituted by 1, 2 or 3 identical or different radicals selected from F, CN, C₁-C₄-alkyl and C₁-C₄-haloalkyl;
wherein
   **Y** is selected from C₆-C₁₄-arylene4- to 14-membered heteroarylene having 1, 2 or 3 identical or different heteroatoms or heteroatom-containing groups as ring members, selected from N, O, S, SO and SO₂, C₁-C₁₀-alkylene, C₃-C₆-cycloalkylene, C₃-C₆-cycloalkenylene, C₁-C₁₀-haloalkylene and C₁-C₁₀-haloalkylarylen;
   wherein arylene and heteroarylene are unsubstituted or substituted by 1, 2, 3, 4 or 5 identical or different radicals R⁵;
   wherein R⁵ is selected from CN, F, Cl, OCF₃, SCF₃, SF₅, SO₂CF₃, C₁-C₄-alkylene, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.

In one embodiment, X is C-H.

In one embodiment Z is C-H.

In another embodiment, X is C-H or Z is C-H.

In one embodiment, X is C-H and Z is C-H.

In one embodiment of the electronic component, in compounds of formula (II.a) Y is selected from n-C₃F₆, n-C₄F₈, n-C₅F₁₀, n-C₆F₁₂, and one of the formulas: 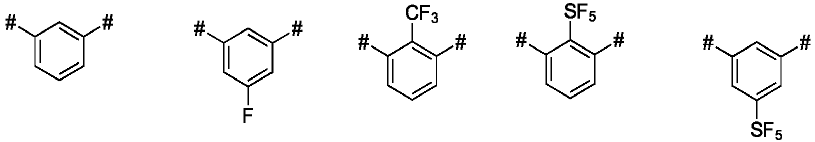 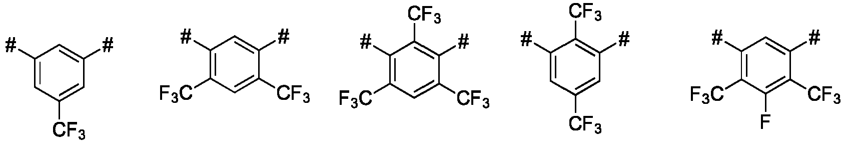 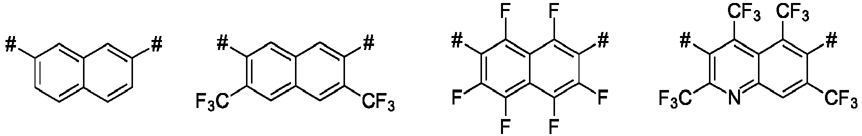 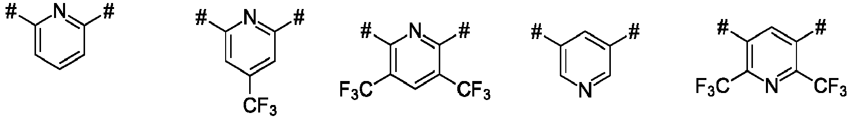 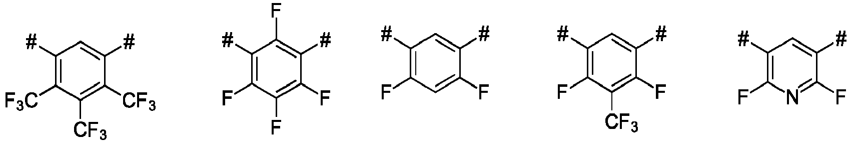 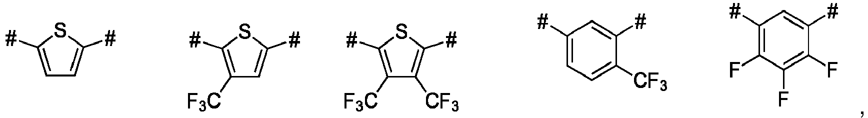 wherein # denotes the bond to the remaining molecule of formula (II.a).

**Preferred is an electronic component** according to the invention, wherein in compounds of formula (II.a) each of R¹, R², R³, and R⁴ are independently selected from CF₃, C₂F₅, n-C₃F₇, n-C₄F₉ and one of the formulas (III.1) - (III.46): 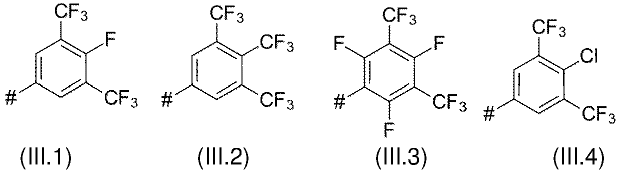 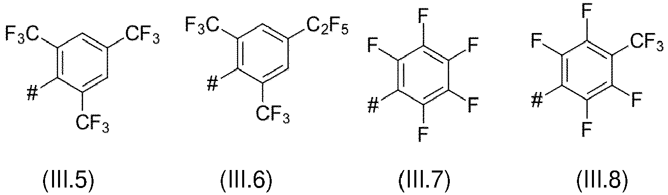 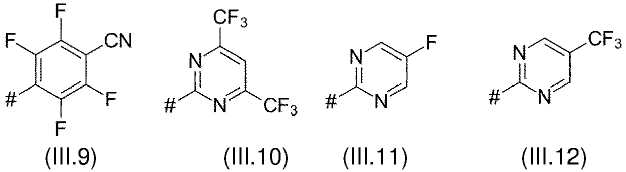 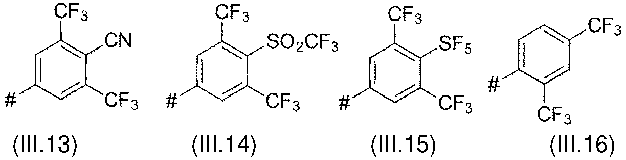 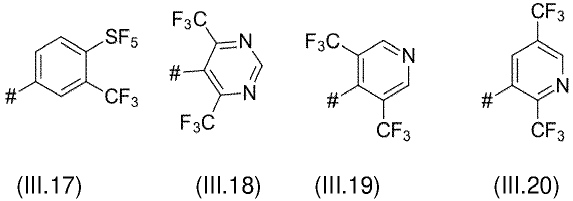 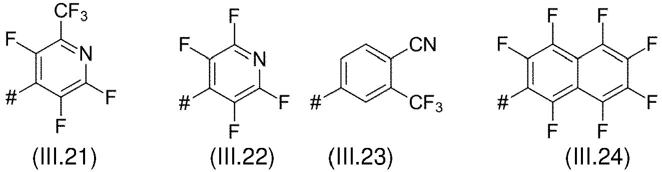 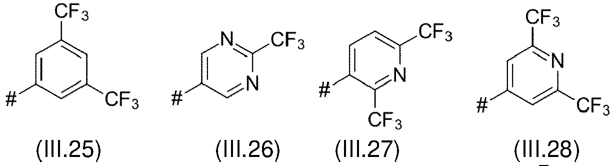 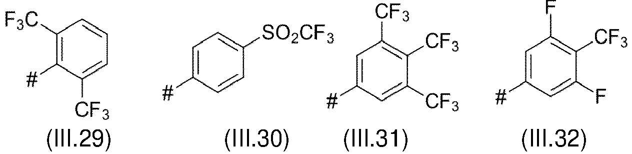 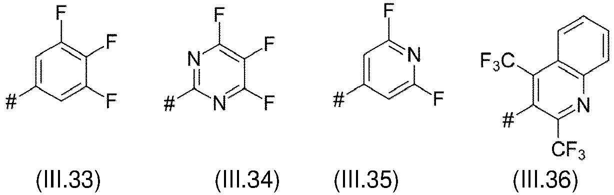 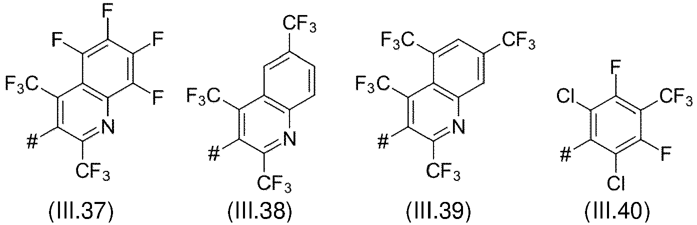 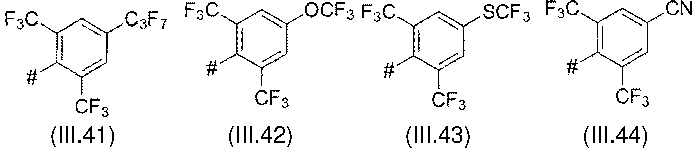 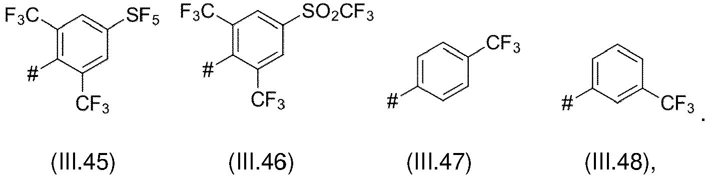 wherein # denotes the bond to the remaining molecule of formula (II.a).

In one embodiment, L_{A}, L_{B}, L_{C} and L_{D} have the same meanings and
In another embodiment at least one ligand of L_{A}, L_{B}, L_{C} and L_{D} has a different meaning than the other ligands.

Preferred is the electronic component according to the invention in form of
- a light-emitting devices, preferably a light-emitting diode,
- a display device,
- a photovoltaic cell,
- an organic photodetector,
- an organic transistor,
- an organic diode,
- an organic laser diode,
- an organic or hybrid solar cell, preferably an organic solar cell or a perovskite solar cell,
- an organic transistor, preferably an organic vertical transistor, or
- a battery.

Preferred is the electronic component according to the invention which comprises at least one hole transport layer and/or at least one hole injection layer and/or at least one hole extraction layer and/or at least one pn-junction and/or one electron transport layer, which comprise at least one or more of the compounds of formula (I) and/or formula (I.a). The pn-junction may comprise at least a p-type charge generation layer and an n-type charge generation layer, wherein preferably the p-type charge generation layer comprises one or more compounds of formula (I) and/or formula (I.a).

### MATRIX MATERIALS

The compounds of the formula (I) and/or formula (I.a) according to the invention, the charge transfer complexes thereof, and the reduction products thereof can be used as dopants in semiconductor matrix materials, in particular as p-dopants in hole transport layers.

Another aspect of the invention is a doped semiconductor layer comprising at least one electron donor, which can also be referred to as semiconductor matrix material, and at least one doping agent, wherein the doping agent is one or more compounds of formula (I) and/or formula (I.a), and/or the charge transfer complexes thereof, and/or the reduction products thereof in particular compounds of formula (I.a), preferably compounds as listed in tables 1 to 7.

According to the invention, a doped semiconductor layer is a combination of two substances or two compounds, in particular, of an semiconductor matrix compound, and at least one doping agent. The doping agent serves as an electron acceptor.

The semiconductor matrix material or semiconductor matrix compound which may also be called the matrix material can consist partially (> 10 or > 25% by weight) or substantially (> 50 % by weight or > 75% by weight) or totally (> 99 %) of a metal phthalocyanine complex, a porphyrine complex, especially metal porphyrine complex, oligothiophene-, oligophenyl-, oligophenylene vinylene- or oligofluorene compound, in which the oligomer preferably comprises 2-500 or more, preferably 2-100 or 2-50 or 2-10 or more monomeric units. The oligomer can also comprise > 4, > 6 or > 10 or more monomeric units, in particular also for the above-indicated ranges, thus, e.g., 4 or 6-10 monomeric units, 6 or 10-100 monomeric units or 10-500 monomeric units. Polymeric matrix materials can also be used. The monomers and oligomers can be substituted or unsubstituted and even block- or mixed polymerizates of the cited oligomers can be present as well as a compound with a triarylamine unit or a carbazole unit or a spiro-bifluorene compound.

The cited semiconductor matrix materials can also be present in combination with each other, optionally also in combination with other matrix materials. The semiconductor matrix materials can have electron-donating substitutents such as alkyl- or alkoxy groups that have a reduced ionizing energy or reduce the ionizing energy of the semiconductor matrix material.

The metal phthalocyanine complexes or porphyrine complexes used as semiconductor matrix material can have a main group metal atom or subgroup metal atom. The metal atom Me can be coordinated 4-, 5- or 6-fold, e.g., in the form of oxo(Me=O), dioxo-(O=Me=O) imine-, diimine-, hydroxo-, dihydroxo-, amino- or diamino complexes, without being limited to them. The phthalocyanine complex or porphyrine complex can each be partially hydrogenated, however, the mesomeric ring system is preferably not disturbed. The phthalocyanine can contain, e.g., magnesium, zinc, iron, nickel, cobalt, magnesium, copper or vanadyl (=VO) as central atom. The same or other metal atoms or oxometal atoms can be present in the case of porphyrine complexes.

In one preferred embodiment the semiconductor matrix material is either selected from phthalocyanine metal (Me) complexes (MePc) or triarylamino based or carbazole based or thiopheno based hole transport materials (HTM).

In particular, such dopable hole transport materials HTM can be arylated benzidines, e.g., N,N'-perarylated benzidines or other diamines such as of the type TPD (in which one, several or all of the aryl groups can have aromatic heteroatoms), suitable arylated starburst compounds such as N,N',N"-perarylated starburst compounds such as the compound TDATA (in which one, several or all of the aryl groups can have aromatic heteroatoms). The aryl groups can comprise phenyl, naphthyl, pyridine, quinoline, isoquinoline, peridazine, pyrimidine, pyrazine, pyrazole, imidazole, oxazole, furan, pyrrole, indole or the like, especially for each of the above-cited compounds. The phenyl groups of the particular compounds can be partially or completely replaced by thiophene groups.

It is understood that even other suitable semiconductor matrix materials/ semiconductor matrix compounds, in particular hole-conducting materials can be used that have semi-conductive properties.

In particular a doped semiconductor matrix material comprises at least one semiconductor matrix material and at least one compound of the formula (I) and/or formula (I.a), wherein the semiconductor matrix materials is selected from4,4',4"-tris(N-(2-naphthyl)-N-phenyl-amino)triphenylamine (2-TNATA), 4,4',4"-tris(N-3-methylphenyl-N-phenyl-amino)triphenylamine (m-MTDATA), N,N,N',N'-tetrakis(4-methoxyphenyl)benzidine (MeO-TPD), (2,2',7,7'-tetrakis-(N,N-diphenylamino)-9,9'-spirobifluorene (spiro-TTB), N,N'-bis(naphthalen-1-yl)-N,N'-bis(phenyl)-benzidine, N,N'-bis(naphthalen-1-yl)-N,N'-bis(phenyl)-9,9-spiro-bifluorene, 9,9-bis[4-(N,N-bis-biphenyl-4-yl-amino)phenyl]-9H-fluorene, 2,2'-bis[N,N-bis(biphenyl-4-yl)amino]-9,9-spiro-bifluorene, N,N'-((9H-fluoren-9,9-diyl)bis(4,1-phenylen))bis(N-([1,1'-biphenyl]-4-yl)-[1,1'-biphenyl]-4-amine) (BPAPF), N,N'-bis(phenanthren-9-yl)-N,N'-bis(phenyl)-benzidine, 1,3,5-tris{4-[bis(9,9-dimethyl-fluoren-2-yl)amino]phenyl}benzene, tri(terphenyl-4-yl)amine, N-(4-(6-((9,9-dimethyl-9H-fluoren-2-yl)(6-methoxy-[1,1'-biphenyl]-3-yl)amino)-1,3,3-trimethyl-2,3-dihydro-1H-inden-1-yl)phenyl)-N-(6-methoxy-[1,1'-biphenyl]-3-yl)-9,9-dimethyl-9H-fluoren-2-amine, N-([1,1'-biphenyl]-4-yl)-N-(4-(6-([1,1'-biphenyl]-4-yl(9,9-dimethyl-9H-fluoren-2-yl)amino)-1,3,3-trimethyl-2,3-dihydro-1H-inden-1-yl)phenyl)-9,9-dimethyl-9H-fluoren-2-amine, N,N-di([1,1'-biphenyl]-4-yl)-3-(4-(di([1,1'-biphenyl]-4-yl)amino)phenyl)-1,1,3-trimethyl-2,3-dihydro-1H-inden-5-amine, N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-(4-(6-(9,9'-spirobi[fluoren]-2-yl(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9'-spirobi[fluoren]-2-amine, N-(4-(6-(dibenzo[b,d]furan-2-yl(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)dibenzo[b,d]furan-2-amine, 9-(4-(6-(9H-carbazol-9-yl)-1,3,3-trimethyl-2,3-dihydro-1H-inden-1-yl)phenyl)-9H-carbazole, N-([1,1'-biphenyl]-4-yl)-3-(4-([1,1'-biphenyl]-4-yl(4-methoxyphenyl)amino)phenyl)-N-(4-methoxyphenyl)-1,1,3-trimethyl-2,3-dihydro-1H-inden-5-amine, 3-(4-(bis(6-methoxy-[1,1'-biphenyl]-3-yl)amino)phenyl)-N,N-bis(6-methoxy-[1,1'-biphenyl]-3-yl)-1,1,3-trimethyl-2,3-dihydro-1H-inden-5-amine, N1-([1,1'-biphenyl]-4-yl)-N1-(4-(6-([1,1'-biphenyl]-4-yl(4-(diphenylamino)phenyl)amino)-1,3,3-trimethyl-2,3-dihydro-1H-inden-1-yl)phenyl)-N4,N4-diphenylbenzene-1,4-diamine, N,N-di([1,1'-biphenyl]-4-yl)-4'-(6-(4-(di([1,1'-biphenyl]-4-yl)amino)phenyl)-1,3,3-trimethyl-2,3-dihydro-1H-inden-1-yl)-[1,1'-biphenyl]-4-amine, N-(4-(5-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N,N'-bis(9,9-dimethyl-fluoren-2-yl)-N,N'-diphenyl-benzidine (BF-DPB), N,N'-((9H-fluorene-9,9-diyl)bis(4,1-phenylene))bis(N-([1,1'-biphenyl]-4-yl)-[1,1'-biphenyl]-4-amine) (BPAPF), N4,N4,N4',N4'-tetrakis(9,9-dimethyl-9H-fluoren-2-yl)-[1,1'-biphenyl]-4,4'-diamine (TDMFB), N-([1,1'-biphenyl]-2-yl)-N-(9,9-dimethyl-9H-fluoren-2-yl)-9,9'-spirobi[fluoren]-2-amine, (2,7-bis[N,N-bis(4-methoxyphenyl)amino]-9,9-spirobi[9H-fluorene] (spiro-MeO-TPD), a mixture of N-(4-(5-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine and N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-([1,1'-biphenyl]-4-yl)-9,9-dimethyl-N-(4-(9-phenyl-9H-carbazol-3-yl)phenyl)-9H-fluoren-2-amine and mixtures thereof.

### DOPING

In particular, the doping can be carried out such that the molar ratio of matrix molecules to the compound of the general formula (I) and/or formula (I.a), is in the range from 10000 : 1 to 1 : 1, preferably from 1000 : 1 to 2 : 1, particularly preferably from 100 : 1 to 5 : 1.

Preferably, the compounds according to the invention are characterized by a high doping efficiency.

Advantageously, the compounds according to the invention exhibit a low absorption when used in the doped layer. Thus, parasitic absorption and emission can be reduced or even prevented.

### EVAPORATION OF THE DOPING AGENTS AND PREPARATION OF THE DOPED SEMICONDUCTOR LAYER

A further object of the invention relates to the doping of the respective semiconductor matrix material (hereinafter also referred to as hole transport material HTM which can also be referred to as hole transport matrix) with the compounds of the general formula (I) and/or formula (I.a) according to the invention and used in accordance with the invention may be carried out by one or a combination of two or more than two of the following processes:
(a) Simultaneous evaporation of the hole transport material and the compound of the general formula (I), preferably in vacuum, preferably with one source for the HTM and one for at least one compound of general formula (I) and/or formula (I.a).
(b) Evaporation of a pre-mixed material containing the HTM and at least one compound of general formula (I) and/or formula (I.a) from one single source.
(c) Sequential deposition of the HTM and at least one compound of general formula (I) and/or formula (I.a). This process step is followed by diffusion of the dopant, i.e. the compound of the general formula (I) and/or formula (I.a) inward upon thermal treatment. The compound of general formula (I) and/or formula (I.a) might be deposited before or after HTM.
(d) Doping of a layer of HTM by a solution of at least one compound of general formula (I) and/or formula (I.a) followed by evaporation of the solvent by thermal treatment.
(e) Surface doping of a layer of a HTM by a layer of at least one compound of general formula (I) and/or formula (I.a) applied to one or both surfaces of the HT layer (hole transport layer), i.e. a layer containing a HTM.
(f) Preparing a solution of a HTM and at least one compound of general formula (I) and/or formula (I.a) and forming a film from the solution, e.g., by coating, casting, printing, or other film-forming techniques known to one skilled in the art.

The **deposition rate** on a substrate with the compound used in accordance with the invention can be determined, e.g., using a quartz thickness monitor, as is customarily used, e.g., in the production of OLEDs. In particular, the ratio of the deposition rates of matrix materials and doping agent can be measured by independent measurements of them using two separate quartz thickness monitors in order to adjust the doping ratio. It is understood that the compounds used in accordance with the invention are preferably such that they evaporate more or less or practically non-decomposed. However, if necessary, even purposeful precursors can be used as doping source that release the compounds used in accordance with the invention, e.g., acid addition salts, e.g., of a volatile or non-volatile inorganic or organic acid, or their charge transfer complexes, which acids and/or electron donors are preferably not volatile or only slightly volatile or the charge transfer complex itself acts as doping agent.

The doping agent used according to the invention is preferably selected in such a manner that the semiconductive matrix material doped with it still has ≥20%, preferably ≥30%, especially preferably ≥50% or 60% of the conductivity (s/cm) of the value at 100°C after a temperature change of 100°C to RT (20°C).

Preferred is a method for the preparation of a doped layer according to the invention of a doped layer, which preferably has been prepared by the method according to the invention, wherein the doped matrix material is heated at a temperature of at least 50-120°C, preferably 80°-105°C, for a time of 1 - 500 minutes, preferably 5 to 200 minutes, more preferably 10 - 150 minutes, even more preferably 20 - 50 minutes. **Annealing** of the deposited layers by heating, preferably at temperatures between 50°C and 120°C, preferably for 1 to 200 min, can advantageously further increase the conductivity of the doped semiconductor layer.

The doping can take place in such a manner that the doping agent is evaporated out of a precursor compound that releases the doping agent under heating and/or irradiation. The irradiation can take place by electromagnetic radiation, especially visible light, UV light or IR light, e.g., by laser light or also by other radiation types. The heat necessary for evaporation can substantially be made available by the irradiation and can also be radiated in a purposeful manner into certain bands of the compounds or precursors or compound complexes such as charge transfer complexes to be evaporated in order to facilitate the evaporation of the compounds by dissociation of the complexes by conversion into excited states. It is understood that the evaporation conditions described in the following are directed to those without irradiation and that uniform evaporation conditions are to be used for purposes of comparison.

For example, the following can be used as precursor compounds:
a) Mixtures or stoichiometric or mixed crystalline compounds of the doping agent and an inert, non-volatile substance, e.g., a polymer, molecular sieve, aluminum oxide, silica gel, and oligomers or another organic or inorganic substance with high evaporation temperature, in which the doping agent is bound primarily by van der Waals forces and/or hydrogen bridge bonding to this substance.
b) Mixture or stoichiometric or mixed crystalline compound of the doping agent and one non-volatile compound V more or less of the electron donor type, in which a more or less complete charge transfer occurs between the doping agent and the compound V as in charge transfer complexes with more or less electron-rich polyaromatics or heteroaromatics or another organic or inorganic substance with high evaporation temperature.
c) Mixture or stoichiometric or mixed crystalline compound of the doping agent and a substance that evaporates together with the doping agent and has the same or higher ionizing energy as the substance HT to be doped, so that the substance does not form a trap for holes in the semiconductor matrix material. According to the invention the substance can also be identical to the semiconductor matrix material here, e.g., be a metal phthalocyanine or benzidine derivative. Further suitable volatile co-substances such as hydroquinones, 1,4-phenylene diamines or 1-amino-4-hydroxybenzene or other compounds form quinhydrones or other charge transfer complexes.

### EXAMPLES

The following examples illustrate the invention without limiting it in any way.

### SYNTHESIS

### SYNTHESIS OF BINUCLEAR COMPLEX D1:

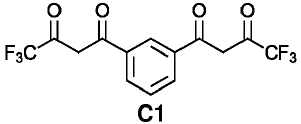

Compound **C1** was prepared according to the procedure described in literature: Z. Sun et al Inorg. Chem. 2013, 52, 9, 5013-5022. 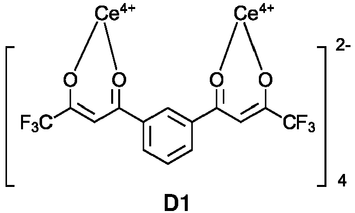 Sodium hydride (260 mg, 60% dispersion in mineral oil, 6.49 mmol) was added in one portion to a solution of tetraketone **C1** (1.15 g, 3.25 mmol) in dimethoxyethane. The resulting mixture was stirred for ten minutes until gas evolution ceased. Subsequently, ceric ammonium nitrate (889 mg, 1.63 mmol) was added in one portion and the resulting mixture was stirred for 15 minutes. The solvent was removed under reduced pressure and resulting solid was washed with water and recrystallized from chlorobenzene yielding cerium complex **D1** (890 mg, 65%) as a red-brown solid.

¹H-NMR (295 K, 80 MHz, d₈-THF): δ (in ppm) = 8.74 (s, 4H), 8.10 - 7.78 (m, 8H), 7.59 - 7.25 (m, 4H), 6.22 (s, 8H).

¹⁹F-NMR (295 K, 76 MHz, d₈-THF): δ (in ppm) = -73.84.

### SYNTHESIS OF BINUCLEAR COMPLEX D2:

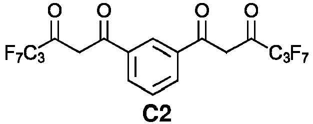

Sodium methoxide (799 mg, 14.8 mmol) was added in one portion to a solution of ethyl heptafluorobutyrate (3.58 g, 14.8 mmol) in anhydrous THF (10 mL) at room temperature. After the resulting suspension was stirred for 10 minutes, 1,3-diacetylbenzene (1.00 g, 6.17 mmol) was added. After 27 hours an additional portion of ethyl heptafluorobutyrate (1.50 g, 6.17 mmol) and sodium methoxide (332 mg, 6.17 mmol) were added. After stirring was continued for additional 17 hours, the reaction mixture was poured on ice water (100 mL). Upon acidification with 3 M aqueous HCl (50 mL) a solid formed. The precipitate was filtered, washed with water (50 mL) and dried under vacuum to yield tetraketone **C2** (3.1253 g, 91%) as a white solid.

APCI-MS: m/z = 555.1[M+H]⁺ 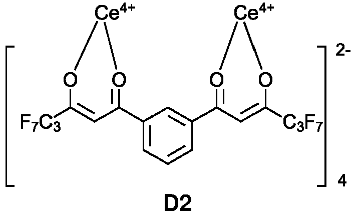 Sodium hydride (144 mg, 60% dispersion in mineral oil, 3.61 mmol) was added in one portion to a solution of tetraketone **C2** (1.00 g, 1.80 mmol) in acetonitrile (30 mL). The resulting mixture was stirred for ten minutes until gas evolution ceased. Subsequently, ceric ammonium nitrate (495 mg, 902 pmol) was added in one portion and the resulting mixture was stirred for 30 minutes. The reaction mixture was filtered and the precipitate was washed with acetonitrile (50 mL) and water (100 mL) and recrystallized from chlorobenzene (100 mL) yielding cerium complex **D2** (890 mg, 25%) as a dark brown solid.

¹H-NMR (295 K, 80 MHz, d₆-acetone): δ (in ppm) = 8.92 (s, 4H), 8.32 - 8.00 (m, 8H), 7.71 - 7.48 (m, 4H), 6.47 (s, 8H).

¹⁹F-NMR (295 K, 76 MHz, d₆-acetone): δ (in ppm) = -79.87 (t, J= 9.1 Hz), -118.47 (d, *J* = 9.3 Hz), -125.54.

### SYNTHESIS OF BINUCLEAR COMPLEX D3:

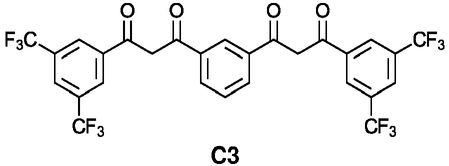

Sodium methoxide (799 mg, 14.8 mmol) was added in one portion to a solution of methyl 3,5-bis(trifluoromethyl)benzoate (4.03 g, 14.8 mmol) in anhydrous THF (20 mL) at room temperature. After the resulting suspension was stirred for 10 minutes, 1,3-diacetylbenzene (1.00 g, 6.17 mmol) was added. After stirring was continued for additional 21 hours, the reaction mixture was poured on ice water (100 mL). Upon acidification with 3 M aqueous HCl (50 mL) a solid formed. The precipitate was filtered, washed with water and dried under vacuum. Recrystallization from isopropanol (250 mL) yielded tetraketone **C3** (2.94 g, 74%) as a white solid.

APCI-MS: m/z = 643.6 [M+H]⁺ 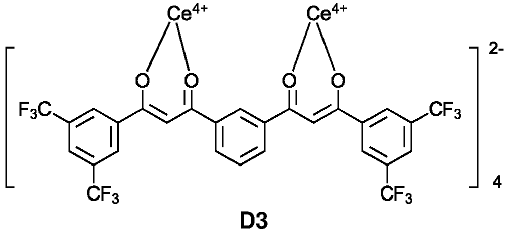 Sodium hydride (62.3 mg, 60% dispersion in mineral oil, 1.56 mmol) was added in one portion to a solution of tetraketone **C3** (500 mg, 0.78 mmol) in dimethoxyethane (20 mL). The resulting mixture was stirred for 25 minutes until gas evolution ceased. Subsequently, ceric ammonium nitrate (213 mg, 0.39 mmol) was added in one portion and the resulting mixture was stirred for 30 minutes. The solvent was removed under reduced pressure and resulting solid was washed with water (50 mL) and recrystallized from chlorobenzene (12 mL) yielding cerium complex **D3** (236 mg, 33%) as a red solid.

¹H-NMR (295 K, 80 MHz, d₆-acetone): δ (in ppm) = 9.71 (s, 4H), 8.67 (s, 16H), 8.50 - 8.10 (m, 20H), 7.28 (s, 8H).

¹⁹F-NMR (295 K, 76 MHz, d₆-acetone): δ (in ppm) = -64.22.

### SYNTHESIS OF BINUCLEAR COMPLEX D4:

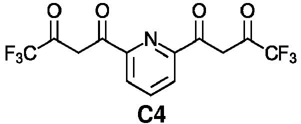

Compound **C4** was prepared according to the procedure described in literature: S. Wang et al. Mater. Chem. Phys. 2018, 217, 486-492. 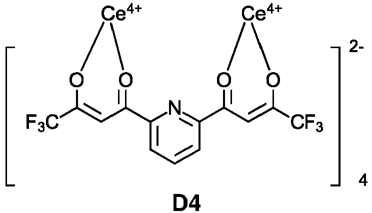 Sodium hydride (113 mg, 60% dispersion in mineral oil, 2.82 mmol) was added in one portion to a solution of tetraketone **C4** (500 mg, 1.41 mmol) in dimethoxyethane (14 mL). The resulting mixture was stirred for ten minutes until gas evolution ceased. Subsequently, ceric ammonium nitrate (387 mg, 0.71 mmol) was added in one portion and the resulting mixture was stirred for 30 minutes. The reaction mixture was filtered and the precipitate was washed with dimethoxyethane (30 mL) and water (50 mL) yielding cerium complex **D4** (318 mg, 53%) as a red solid.

¹H-NMR (295 K, 80 MHz, d₆-DMSO): δ (in ppm) = 8.61 - 7.95 (m, 12H), (m, 8H).

¹⁹F-NMR (295 K, 76 MHz, d₆-DMSO): δ (in ppm) = -76.20.

### SYNTHESIS OF BINUCLEAR COMPLEX D5:

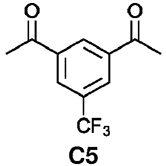

3,5-Dibromobenzotrifluoride (2.00 g, 6.6 mmol), butyl vinyl ether (3.95 g, 39.5 mmol), palladium(II) acetate (118 mg, 0.5 mmol), 1,3-bis(diphenylphosphino)propane (582 mg, 1.05 mmol) and triethylamine (3.33 g, 32.9 mmol) were dissolved in isopropanol (13 mL) in a microwave vial. Argon was bubbled through the resulting solution for 5 minutes and the vial was sealed. The reaction mixture was heated to 115 °C for 4 days. After cooling the mixture to room temperature, 3 M aqueous HCl (30 mL) was added and stirring was continued for 30 minutes. The resulting mixture was extracted with CH₂Cl₂ (3 × 30 mL) and the combined organic phases were dried over Na₂SO₄. After evaporation of solvents, the crude reaction mixture was filtered over a plug of silica (PE to PE/MTBE = 10:1 to PE/MTBE = 7:3). Evaporation of solvents yielded acetophenone **C5** (950 mg, 63%) as a white solid.

APCI-MS: m/z = 231.2 [M+H]⁺ 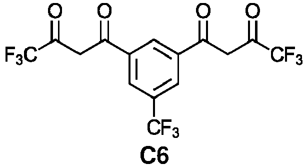 Sodium methoxide (535 mg, 9.91 mmol) was added in one portion to a solution of ethyl trifluoroacetate (1.41 g, 9.91 mmol) in anhydrous THF (8 mL) at room temperature. After the resulting suspension was stirred for 10 minutes, acetophenone **C5** (950 mg, 4.13 mmol) was added. After 18 hours the reaction mixture was poured on ice water (100 mL) and acidified with 3 M aqueous HCl (30 mL). The resulting mixture was extracted with CH₂Cl₂ (3 × 30 mL) The combined organic phases were dried over Na₂SO₄ and the solvents were removed under reduced pressure to yield tetraketone **C6** (1.63 g, 94%) as an off-white solid.

APCI-MS: m/z = 423.3 [M+H]⁺ 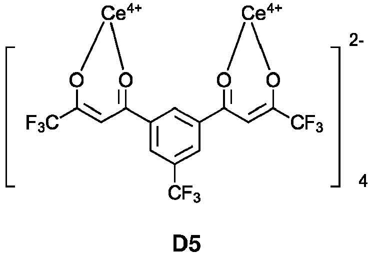 Sodium hydride (115 mg, 60% dispersion in mineral oil, 2.86 mmol) was added in one portion to a solution of tetraketone **C6** (605 mg, 1.43 mmol) in acetonitrile (15 mL). The resulting mixture was stirred for ten minutes until gas evolution ceased. Subsequently, ceric ammonium nitrate (393 mg, 0.72 mmol) was added in one portion and the resulting mixture was stirred for 30 minutes. The solvent was evaporated and resulting solid was washed with water yielding cerium complex **D5** (598 mg, 85%) as a red-brown solid.

APCI-MS: m/z = 1961.4 [M+H]⁺

### SYNTHESIS OF BINUCLEAR COMPLEX D6:

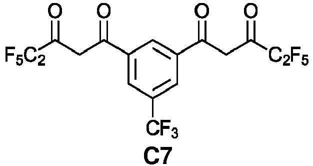

Sodium methoxide (282 mg, 5.21 mmol) was added in one portion to a solution of ethyl pentafluoropropionate (1.00 g, 5.21 mmol) in anhydrous THF (5 mL) at room temperature. After the resulting suspension was stirred for 10 minutes, acetophenone **C5** (500 mg, 2.17 mmol) was added. After 17 hours the reaction mixture was poured on ice water (100 mL) and acidified with 3 M aqueous HCl (50 mL). The resulting mixture was extracted with MTBE (3 × 50 mL). The combined organic phases were dried over Na₂SO₄ and the solvents were removed under reduced pressure to yield tetraketone **C7** (1.13 g, 100%) as an off-white solid.

APCI-MS: m/z = 523.7 [M+H]⁺ 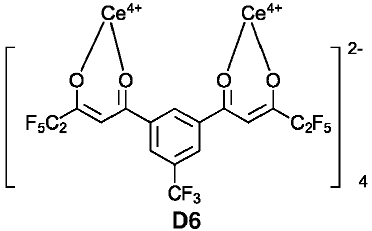 Sodium hydride (173 mg, 60% dispersion in mineral oil, 4.33 mmol) was added in one portion to a solution of tetraketone **C7** (1.13 g, 2.16 mmol) in acetonitrile (40 mL). The resulting mixture was stirred for ten minutes until gas evolution ceased. Subsequently, ceric ammonium nitrate (593 mg, 1.08 mmol) was added in one portion and the resulting mixture was stirred for 60 minutes. The reaction mixture was filtered, and the precipitate was washed water (30 mL) and CH₂Cl₂ (30 mL) yielding cerium complex **D6** (1.04 g, 82%) as a red-brown solid.

¹H-NMR (295 K, 80 MHz, d₆-acetone): δ (in ppm) = 8.88 (s, 4H), 8.40 (m, 8H), 6.60 (s, 8H). ¹⁹F-NMR (295 K, 76 MHz, d₆-acetone): δ (in ppm) = -61.78, -81.94, -121.45.

### SYNTHESIS OF BINUCLEAR COMPLEX D7:

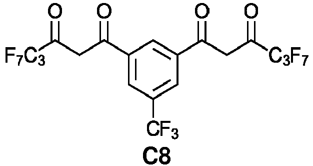

Sodium methoxide (563 mg, 10.4 mmol) was added in one portion to a solution of ethyl heptafluorobutanoate (2.52 g, 10.4 mmol) in anhydrous THF (10 mL) at room temperature. After the resulting suspension was stirred for 10 minutes, acetophenone **C5** (1.00 g, 4.34 mmol) was added. After 17 hours the reaction mixture was poured on ice water (100 mL) and acidified with 3 M aqueous HCl (50 mL). The resulting precipitate was collected after filtration. The filtrate was extracted with MTBE (3 × 50 mL). The combined organic phases were dried over Na₂SO₄ and the solvents were removed under reduced pressure. The combined products were dried under vacuum yielding tetraketone **C8** (2.70 g, 99%) as an off-white solid.

APCI-MS: m/z = 623.3 [M+H]⁺ 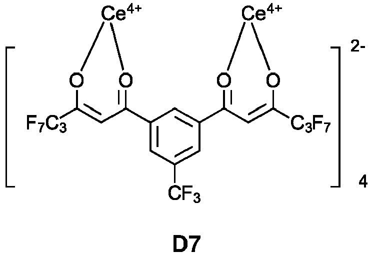 Sodium hydride (84 mg, 60% dispersion in mineral oil, 2.1 mmol) was added in one portion to a solution of tetraketone **C8** (651 mg, 1.05 mmol) in acetonitrile (20 mL). The resulting mixture was stirred for ten minutes until gas evolution ceased. Subsequently, ceric ammonium nitrate (287 mg, 0.52 mmol) was added in one portion and the resulting mixture was stirred for 30 minutes. The reaction mixture was filtered, and the precipitate was washed with water (30 mL) and CH₂Cl₂ (30 mL) yielding cerium complex **D7** (628 mg, 87%) as a red-brown solid.

¹H-NMR (295 K, 80 MHz, d₆-acetone): δ (in ppm) = 8.93 (s, 4H), 8.40 (m, 8H), 6.62 (s, 8H).

¹⁹F-NMR (295 K, 76 MHz, d₆-acetone): δ (in ppm) = -61.64, -79.90 (t, J = 9.0 Hz), -118.40 (d, J = 9.0 Hz), -125.31 - -125.50 (m).

### SYNTHESIS OF BINUCLEAR COMPLEX D8:

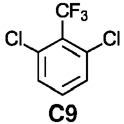

Compound **C9** was prepared according to the procedure described in literature: M. Schlosser et al. Eur. J. Org. Chem. 2006, 19, 4398-4404. 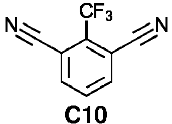 Palladium(II) acetate (118.8 mg, 0.53 mmol), 2,2'-bipyridine (826 mg, 5.3 mmol), 1,4-bis(diphenylphosphino)butane (451 mg, 1.1 mmol) and potassium cyanide (1.52 g, 23.3 mmol) were added to a microwave vial and suspended in toluene (10.6 mL). Argon was bubbled through the suspension for 10 minutes, 1,3-dichloro-2-(trifluoromethyl)benzene **C9** (2.276 g, 10.6 mmol) was added, the vial was sealed and heated to 160 °C for 24 hours. After cooling the reaction mixture to room temperature, CH₂Cl₂ (100 mL) and water (100 mL) were added, phases were separated and the organic phase was washed with 3 M aqueous HCl (3 × 50 mL) and dried over MgSO₄. Solvents were evaporated and the crude reaction mixture was filtered over a pad of silica (PE/EA = 9:1 to PE/EA = 7:3). Evaporation of solvents yielded dinitrile **C10** (1.850 g, 89%) as an off-white solid.

APCI-MS: m/z = 197.1 [M+H]⁺ 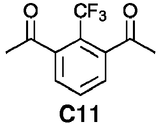 Methylmagnesium bromide (18.25 mL, 3 M in THF, 54.75 mmol) was added dropwise to a solution of dinitrile **C10** (1.795 g, 9.15 mmol) in THF (10 mL). The resulting dark red mixture was heated to 50 °C for 2.5 hours. After cooling the reaction mixture to 0 °C, 3 M aqueous HCl (50 mL, 150 mmol) was added, and the resulting solution was heated to 70 °C for 2 hours. After cooling the mixture to room temperature, water (50 mL) was added and the resulting mixture was extracted with CH₂Cl₂ (3 × 50 mL). The combined organic phases were dried over Na₂SO₄ and the solvents were evaporated. The crude reaction mixture was filtered over a pad of silica gel (PE/EA = 7:2 to PE/EA = 7:4) yielding diacetophenone **C11** as a dark solid (710 mg, 34%).

APCI-MS: m/z = 231.2 [M+H]⁺ 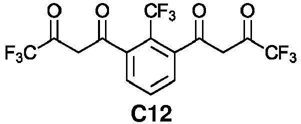 Sodium methoxide (266 mg, 4.93 mmol) was added in one portion to a solution of ethyl trifluoroacetate (700 mg, 4.93 mmol) in anhydrous THF (6 mL) at room temperature. After the resulting suspension was stirred for 10 minutes, acetophenone **C11** (473 mg, 2.05 mmol) in THF (3 mL) was added. After 16 hours the reaction mixture was poured on ice water (100 mL) and acidified with 3 M aqueous HCl (50 mL). The resulting mixture was extracted with MTBE (3 × 50 mL). The combined organic phases were dried over Na₂SO₄ and the solvents were removed under reduced pressure. The resulting crude product was recrystallized from hexanes yielding tetraketone **C12** (598 mg, 69%) as colorless crystals.

APCI-MS: m/z = 423.2 [M+H]⁺ 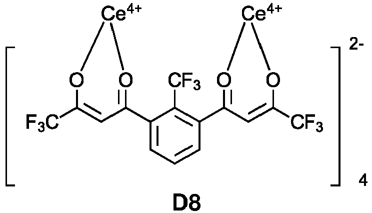 Sodium hydride (93 mg, 60% dispersion in mineral oil, 2.32 mmol) was added in one portion to a solution of tetraketone **C12** (488 mg, 1.16 mmol) in acetonitrile (10 mL). The resulting mixture was stirred for 25 minutes until gas evolution ceased. Subsequently, ceric ammonium nitrate (317 mg, 0.58 mmol) was added in one portion and the resulting mixture was stirred for 30 minutes. The solvent was evaporated, and the resulting solid was washed with water (30 mL) and CH₂Cl₂ (30 mL) yielding cerium complex **D8** (413 mg, 73%) as a red-brown solid.

The characterization of complex **D8** by NMR spectroscopy failed due to its insolubility in common solvents. Nevertheless, the properties of the material indicated the formation of complex **D8.**

### SYNTHESIS OF BINUCLEAR COMPLEX D9:

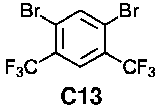

Compound **C13** was prepared according to the procedure described in literature: A. Rajca et al. Polyhedron 2001, 20, 1669-1675. 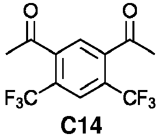 n-BuLi (2.5 mL, 2.5 M in hexanes, 6.3 mmol) was added dropwise to a solution of dibromide **C13** (1.10 g, 2.96 mmol) in diethyl ether (5 mL) at -78 °C. The resulting mixture was slowly warmed to 0 °C and stirred for 15 minutes. Meanwhile, a solution of acetic anhydride (5 mL) in diethyl ether (3 mL) was cooled to -78 °C. Subsequently, the solution containing the lithiated dibromide was added dropwise to the solution containing acetic anhydride over 30 min. The resulting mixture was slowly warmed to room temperature and stirred for 80 minutes. Water (10 mL) was added to the reaction mixture and the aqueous phase was then extracted with MTBE (3 × 20 mL). The combined organic phases were washed with a saturated aqueous NaHCOs solution (50 mL) and dried over MgSO₄. After evaporation of solvents, the crude product was filtered over a pad of silica (PE to PE:MTBE = 10:1 to PE/MTBE = 8:2) yielding acetophenone **C14** (468 mg, 53%) as a yellowish solid.

APCI-MS: m/z = 299.4 [M+H]⁺ 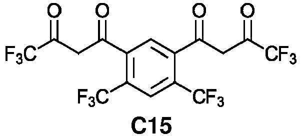 Sodium methoxide (131 mg, 2.41 mmol) was added in one portion to a solution of ethyl trifluoroacetate (343 mg, 2.41 mmol) in anhydrous THF (3 mL) at room temperature. After the resulting suspension was stirred for 10 minutes, acetophenone **C14** (300 mg, 1.01 mmol) was added. After 3 hours the reaction mixture was quenched with water (20 mL) and acidified with 3 M aqueous HCl (10 mL). The resulting mixture was extracted with MTBE (3 × 30 mL). The combined organic phases were dried over Na₂SO₄ and the solvents were removed under reduced pressure yielding tetraketone **C15** (462 mg, 94%) as an off-white solid.

APCI-MS: m/z = 491.6 [M+H]⁺ 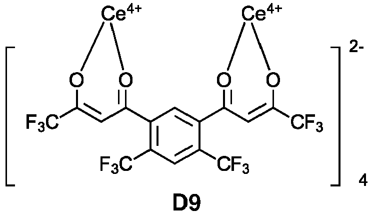 Sodium hydride (73 mg, 60% dispersion in mineral oil, 1.81 mmol) was added in one portion to a solution of tetraketone **C15** (445 mg, 0.91 mmol) in acetonitrile (10 mL). The resulting mixture was stirred for 15 minutes until gas evolution ceased. Subsequently, ceric ammonium nitrate (249 mg, 0.45 mmol) was added in one portion and the resulting mixture was stirred for 25 minutes. The solvent was evaporated, and the resulting solid was washed with water (30 mL) and CH₂Cl₂ (30 mL) yielding cerium complex **D9** (369 mg, 73%) as a red-brown solid.

¹H-NMR (295 K, 80 MHz, d₈-THF): δ (in ppm) = 8.19 (s, 4H), 7.38 (s, 4H), 5.94 (s, 8H).

¹⁹F-NMR (295 K, 76 MHz, d₈-THF): δ (in ppm) = -56.32, -74.70.

### SYNTHESIS OF BINUCLEAR COMPLEX D10:

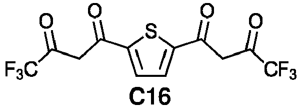

Compound **C16** was prepared according to the procedure described in literature: P. Yan et al. Dalton Trans., 2016, 45, 11459-11470. 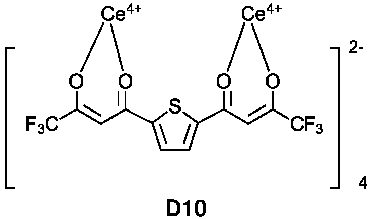 Sodium hydride (76 mg, 60% dispersion in mineral oil, 1.94 mmol) was added in one portion to a solution of tetraketone **C16** (350 mg, 0.97 mmol) in acetonitrile (10 mL). The resulting mixture was stirred for 10 minutes until gas evolution ceased. Subsequently, ceric ammonium nitrate (266 mg, 0.49 mmol) was added in one portion and the resulting mixture was stirred for 30 minutes. The solvent was evaporated, and the resulting solid was washed with water (30 mL) and CH₂Cl₂ (30 mL) yielding cerium complex **D10** (288 mg, 69%) as a red-brown solid.

¹H-NMR (295 K, 80 MHz, d₆-DMSO): δ (in ppm) = 8.25 (s, 8H), 6.59 (m, 8H).

¹⁹F-NMR (295 K, 76 MHz, d₆-DMSO): δ (in ppm) = -70.76.

### SAMPLE PREPARATION AND CONDUCTIVITY MEASUREMENT

To determine the **evaporation temperature,** 15 mg of the material was filled in an aluminum oxide crucible of a point source and heated in a vacuum chamber (base pressure <5 × 10-7 mbar) at 5 K/min until an evaporation rate of 0.3 Å/s is reached. The evaporation rate is monitored with a quartz crystal microbalance (QCM). The rate is kept constant for 10 min by controlling the heating and the evaporation temperature is determined by measuring the temperature at the bottom of the crucible with a thermocouple. To achieve stable evaporation rates and to avoid cross contamination in mass production of organic electronic devices, such as OLEDs, it is advantageous to use materials with a high evaporation temperature of at least above 120°C. Advantageously, evaporation temperatures above 120°C reduce the risk of cross contamination during thermal evaporation in vacuum and are accordingly suitable for mass production.

For the measurement of the **lateral conductivity,** a transmission line method was used. Interdigitated ITO (indium tin oxide) electrodes were formed by photolithography on a glass substrate with four different channel lengths (40 µm, 80 µm, 120 µm, 160 µm). Then organic layers were deposited by thermal evaporation under ultrahigh vacuum conditions (base pressure <5 × 10 -7 mbar) by controlling the evaporation rates with quartz crystal microbalances (QCMs). First, a 10 nm thick p-doped layer was prepared by co-evaporation of the p-dopant and the semiconductor matrix material. To obtain a specific dopant concentration, the individual deposition rates were controlled with independent QCMs. These films were covered with 100 nm of intrinsic semiconductor matrix material to mimic the typical layer stack (common hole-injection layer + common hole-transport layer) in OLED display. Samples were encapsulated with glass lid and getter material under nitrogen atmosphere and characterized ex-situ at room temperature. Current-voltage characteristics (-10 V to 10 V) were measured using a source-measure unit Keithley 2400 and the lateral conductivity was determined from the slope of the resistance vs. channel length plot and by normalizing to the thickness of the p-doped layer, accounting for almost the entire current.

As semiconductor matrix material, HT-1 (N-([1,1'-Biphenyl]-4-yl)-9,9-dimethyl-N-(4-(9-phenyl-9H-carbazol-3-yl)phenyl)-9H-fluoren-2-amine), HT-2 (N-(9,9-Diphenyl-9H-flu-oren-2-yl)-N,9-diphenyl-9H-carbazol-3-amine), and HT-3 (9,9-bis[4-(N,N-bis-biphenyl-4-yl-amino)phenyl]-9H-fluorene) were used. HT-1, HT-2, and HT-3 have a HOMO level of about -5.15 eV, -5.08 eV, and -5.28 eV, respectively, wherein the HOMO level is measured by cyclic voltammetry as described herein.

The **HOMO level** was determined by cyclic voltammetry measured with a platinum working and counter electrode, an Ag/AgCI reference electrode and Ferrocene/Ferro-cenium as an internal standard and a scan rate of 0.1 V/s. As electrolyte, acetonitrile with 0.1M tetrabutylammonium hexafluorophosphate was used. The HOMO level was calculated from E(HOMO) = -4.79 eV - E_{1/2}(oxidation vs. Fc/Fc+).

### TECHNICAL EFFECT

**Table 8:**

| p-Dopant | T_evap |
|---|---|
| D2 | 231 °C |
| D5 | 227°C |

**Table 9:**

| p-Dopant | HTM | Dopant concentration (wt%) | Conductivity in S/cm |
|---|---|---|---|
| None | HT-1 | 0 | <1E-8 |
| D2 | HT-1 | 10 | 1.1E-5 |
| D5 | HT-1 | 10 | 8.9E-5 |
| None | HT-2 | 0 | <1E-8 |
| D2 | HT-2 | 10 | 0.6E-5 |
| D5 | HT-2 | 10 | 1.7E-5 |
| None | HT-3 | 0 | <1E-8 |
| D2 | HT-3 | 10 | 0.01E-5 |
| D5 | HT-3 | 10 | 6.9E-5 |

A technical effect is shown in Table 8. As can be seen from Table 8, Inventive examples D2 and D5 show high evaporation temperatures, significantly above 120°C. Accordingly, these materials can advantageously be used for mass production using thermal evaporation. To achieve stable evaporation rates and to avoid cross contamination in mass production of organic electronic devices, such as OLEDs, it is advantageous to use materials with a high evaporation temperature of at least above 120°C, preferably above 150°C. Advantageously, evaporation temperatures above 120°C reduce the risk of cross contamination during thermal evaporation in vacuum and are accordingly suitable for mass production.

Another technical effect is shown in Table 9, which shows that inventive examples D2 and D5 lead to conductivities above 1E-6 S/cm for semiconductor matrix materials with shallow HOMO, such as HT-1 and HT-2, and should therefore be suitable for use in OLED. Inventive example D5 leads to conductivities well above 1E-6 S/cm even for semiconductor matrix materials with deeper HOMO, such as HT-3.

Especially the possibility of doping matrix materials with deep HOMOs is a critical aspect in order to further improve the efficiency of organic electronic components. In organic solar cells, the application of doped semiconductors with a deep HOMO level may increase the achievable built-in voltage and may accordingly improve the power conversion efficiency. In OLEDs, the use of doped semiconductors with a deep HOMO in the hole injection or hole transport layer enables the use of new more efficient materials in the emitting layer while maintaining a low operating voltage, which is beneficial to achieve higher power efficiencies. Therefore, it is highly relevant to improve the doping of matrix materials with deep HOMO levels or deep HOMO energies.

In summary, the inventive examples both show high evaporation temperatures suitable for mass production and lead to conductivities of semiconductor matrix materials that allow for application in OLED display.

## Claims

1. **An electronic component** comprising at least one compound according to formula (I)
[Ce⁴⁺]₂[(L)ₙ]⁸⁻ (I),
wherein n is an integer from 1 to 8,
wherein L is independently of each other a ligand with at least five carbon atoms.

2. The electronic component according to claim 1, wherein n is 4 or n is 2.

3. **The electronic component** according to claim 1 or 2, wherein n is 4 and L is a bis-bidentate ligand, comprising at least one compound of the formula (I.a):
[Ce⁴⁺]₂L_{A}²⁻L_{B}²⁻L_{C}²⁻L_{D}²⁻ (I.a)
or their single reduced species or their twice reduced species or their charge transfer complexes with donors, wherein L_{A},L_{B},L_{C},L_{D} have the same or different meanings,
wherein
L_{A}, L_{B}, L_{C} and L_{D} are each a bis-bidentate ligand independently selected from formula (Il.a) 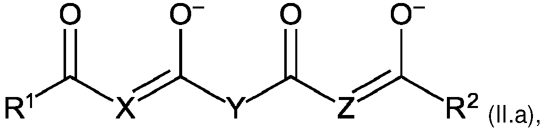 wherein
**X** is selected from C-H, C-CF₃ and C-R³;
**Z** is selected from C-H, C-CF₃ and C-R⁴;
**R¹, R², R³ and R⁴** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl or C₁-C₆-haloalkyl,
wherein aryl and heteroaryl are unsubstituted or substituted by 1, 2, 3, 4 or 5 identical or different radicals R⁵;
wherein R⁵ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein
**Y** is selected from C₆-C₁₄-arylene, 4- to 14-membered heteroarylene having 1, 2 or 3 identical or different heteroatoms or heteroatom-containing groups as ring members, selected from N, O, S, SO and SO₂, C₁-C₁₀-alkylene, C₃-C₆-cycloalkylene, C₃-C₆-cycloalkenylene, C₁-C₁₀-haloalkylene, C₁-C₁₀-haloalkylarylene, S, S-O, O, P-**R⁶**, P-O-R⁷, Si-(R⁸)₂, B-R⁹ and N-R¹⁰;
wherein arylene and heteroarylene are unsubstituted or substituted by 1, 2, 3, 4 or 5 identical or different radicals R⁵;
wherein R⁵ is selected from CN, F, Cl, OCF₃, SCF₃, SF₅, SO₂CF₃, C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl
wherein **R⁶** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R⁷** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R⁸** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkylene;
wherein **R⁹** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R¹⁰** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.

4. The electronic component according to any one of the claims 2 or 3, wherein X is C-H and Z is C-H.

5. **An electronic component** according to any one of the claims 2 to 4, wherein in compounds of formula (II.a) Y is selected from n-C₃F₆, n-C₄F₈, n-C₅F₁₀, n-C₆F₁₂, and one of the formulas: 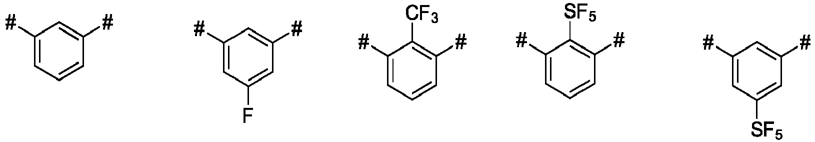 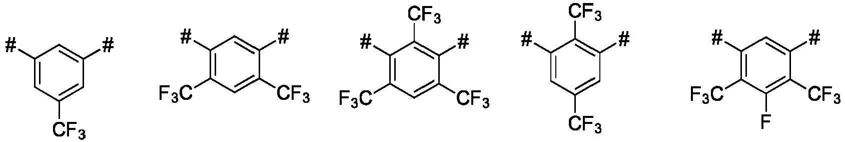 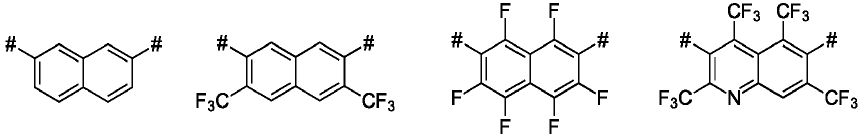 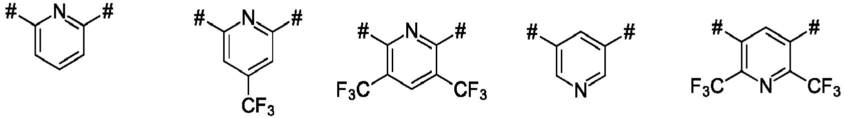 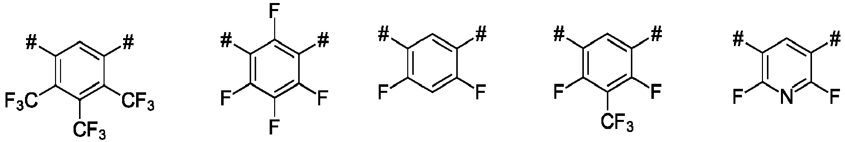 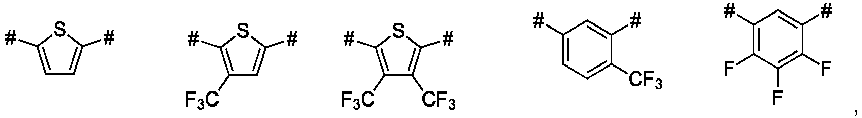 wherein # denotes the bond to the remaining molecule of formula (II.a).

6. **The electronic component** according to any one of the claims 1 to 5, wherein in compounds of formula (II.a) each of R¹, R², R³, and R⁴ can be independently selected from CF₃, C₂F₅, n-C₃F₇, n-C₄F₉ and one of the formulas (III.1) - (III.48): 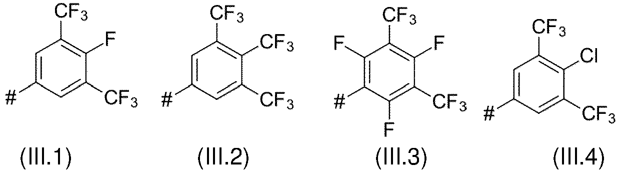 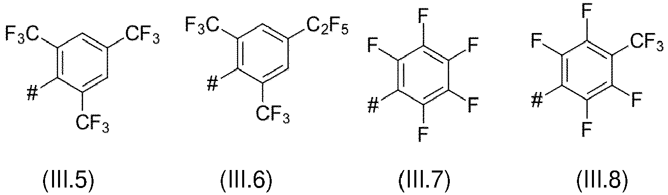 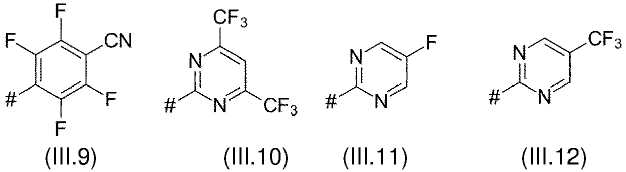 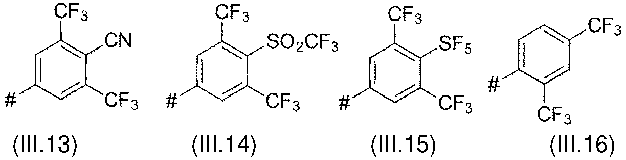 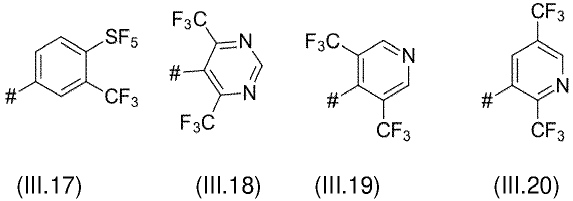 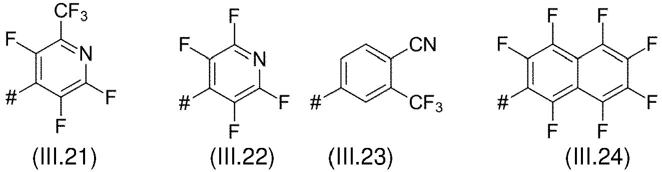 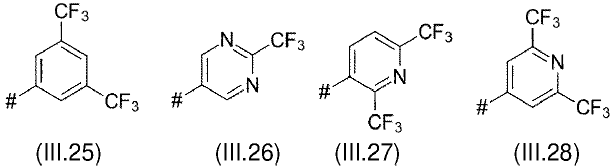 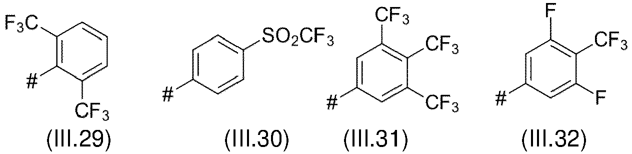 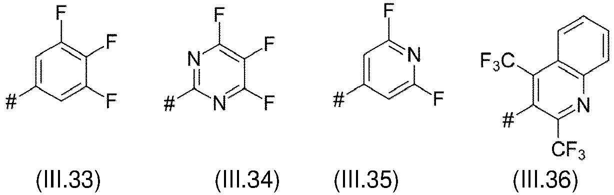 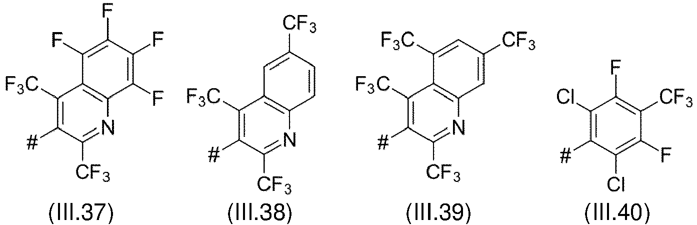 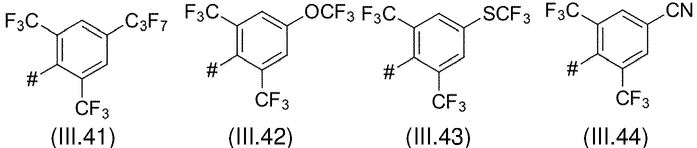 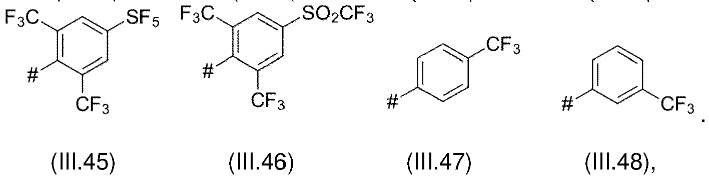 wherein # denotes the bond to the remaining molecule of formula (II.a).

7. The electronic component according to any one of the claims 3 to 6, wherein L_{A}, L_{B}, L_{C} and L_{D} in formula (I.a) have the same meanings or wherein at least one ligand of L_{A}, L_{B}, L_{C} and L_{D} has a different meaning than the other ligands.

8. The electronic component according to any one of the claims 1 to 8 in form of
- a light-emitting devices, preferably a light-emitting diode,
- a display device,
- a photovoltaic cell,
- an organic photodetector,
- an organic transistor,
- an organic diode,
- an organic laser diode,
- an organic or hybrid solar cell,
- an organic transistor, preferably an organic vertical transistor, or
- a battery.

9. The electronic component according to any one of the claims 1 to 8, comprising at least one hole transport layer and/or at least one hole injection layer and/or at least one hole extraction layer and/or at least one pn-junction and/or one electron transport layer, which comprise at least one or more of the compounds of formula (I) or formula (I.a).

10. A compound of formula (I)
[Ce⁴⁺]₂[(L)ₙ]⁸⁻ (I),
wherein n is an integer from 1 to 8,
wherein L is independently of each other a ligand with at least five carbon atoms, with the proviso that compounds with the CAS-number 2097642-18-5, 1632455-28-7, 2097642-24-3, 2241999-19-7, 2097135-12-9, 2241999-18-6, 1624620-72-9, 1624620-73-0, 1626423-31-1 and 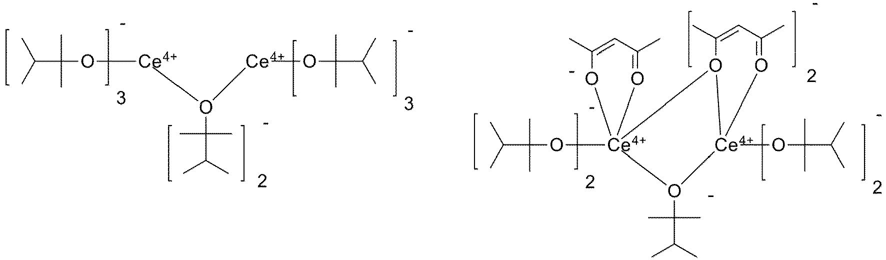 are excluded.

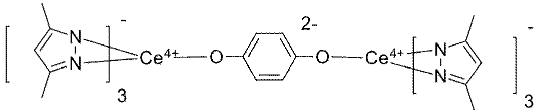

11. A compound according to claim 10, wherein n is 4 and L is a bis-bidentate ligand, comprising at least one compound of the formula (I.a):
[Ce⁴⁺]₂L_{A}²⁻L_{B}²-L_{C}²⁻L_{D}²⁻ (I.a)
or their single reduced species or their twice reduced species or their charge transfer complexes with donors, wherein L_{A},L_{B},L_{C},L_{D} have the same or different meanings,
/ wherein
L_{A}, L_{B}, L_{C} and L_{D} are each a bis-bidentate ligand independently selected from formula (Il.a) 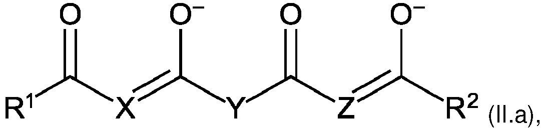 wherein
**X** is selected from C-H, nitrogen (N), C-CF₃ and C-R³;
**Z** is selected from C-H, nitrogen (N), C-CF₃ and C-R⁴;
**R¹, R², R³ and R⁴** independently from each other represent C₆-C₁₄-aryl, 4- to 14-membered heteroaryl having 1, 2 or 3 identical or different heteroatoms or heteroatom-containing groups as ring members, selected from N, O, S, SO and SO₂, C₁-C₁₀-alkyl, C₃-C₆-cycloalkyl orC₁-C₆-haloalkyl;
wherein aryl and heteroaryl are unsubstituted or substituted by 1, 2, 3, 4 or 5 identical or different radicals R⁵;
wherein R⁵ is selected from CN, F, Cl, OCF₃, SCF₃, SF₅, SO₂CF₃, C₁-C₄-alkyl, C₁-C₄-haloalkyl, or C₆-C₁₄-aryl, which is unsubstituted or substituted by 1, 2 or 3 identical or different radicals selected from F, CN, C₁-C₄-alkyl and C₁-C₄-haloalkyl,
wherein
**Y** is selected from C₆-C₁₄-arylene, 4- to 14-membered heteroarylene having 1, 2 or 3 identical or different heteroatoms or heteroatom-containing groups as ring members, selected from N, O, S, SO and SO₂, C₁-C₁₀-alkylene, C₃-C₆-cycloalkylene, C₃-C₆-cycloalkenylene, C₁-C₁₀-haloalkylene, C₁-C₁₀-haloalkylarylene, S, S-O, O, P-**R⁶**, P-O-R⁷, Si-(R⁸)₂, B-R⁹ and N-R¹⁰;
wherein arylene and heteroarylene are unsubstituted or substituted by 1, 2, 3, 4 or 5 identical or different radicals R⁵;
wherein R⁵ is selected from CN, F, Cl, OCF₃, SCF₃, SF₅, SO₂CF₃, C₁-C₄-alkyl, C₁-C₄-haloalkyl, or C₆-C₁₄-aryl, which is unsubstituted or substituted by 1, 2 or 3 identical or different radicals selected from F, CN, C₁-C₄-alkyl and C₁-C₄-haloalkyl;
wherein **R⁶** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R⁷** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R⁸** is selected from C₁-C₄-alkyl, C₁-C₄-haloalkyl and C₆-C₁₄-arylene, which is unsubstituted or substituted by 1, 2 or 3 identical or different radicals selected from F, CN, C₁-C₄-alkyl and C₁-C₄-haloalkyl;
wherein **R⁹** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl;
wherein **R¹⁰** is selected from C₁-C₄-alkyl, C₁-C₄-haloalkyl and C₆-C₁₄-aryl, which is unsubstituted or substituted by 1, 2 or 3 identical or different radicals selected from F, CN, C₁-C₄-alkyl and C₁-C₄-haloalkyl.

12. **A doped semiconductor layer** comprising at least one electron donor and at least one doping agent, wherein the doping agent is a compound of the formula (I) or (I.a) as defined in any one of the claims 1 to 11.

13. A **use** of the compound of formula (I) or (I.a) according to claim 10 or 11 as semiconductor,
- as a redox doping agent in semiconductor layers,
- as p-dopant in hole transport layers,
- as charge injector in a charge injection layer,
- as charge extractor in a charge extraction layer,
- as a sublayer of a pn-junction, especially as a sublayer of a charge-generation layer or a charge conversion layer
- as acceptor compound in charge-transfer complexes,
- as cathode material in organic and redox flow batteries,
- as electrochromic material.

14. The **use** of at least one compound of formula (I) or (I.a) as defined in any of the claims 1 to 11, **as doping agent** for the doping of an semiconductive layer, as absorbing layer, as charge injection layer, or as semiconductor itself.

15. **The Use** of reduced species of the compound of the general formula (I) or (I.a) as defined in any one of the claims 1 to 11 or of charge transfer complexes of a compound of formula (I) or (I.a) as defined in any one of claims 1 to 11 **with electron donors as semiconductor or as electrochromic material.**

16. **A method for the preparation of a doped semiconductor layer,** wherein a hole transport material and a compound of general formula (I) or (I.a) according to one of the claims 12 or 13 is used, comprising at least one of the following steps:
(a) Simultaneous evaporation of the hole transport material and the compound of formula (I) or (I.a),
(b) Evaporation of a pre-mixed material containing the hole transport material and at least one compound of general formula (I) from one single source,
(c) Sequential deposition of the hole transport material and at least one compound of general formula (I) or (I.a),
(d) Doping of a hole transport layer by a solution containing at least one compound of general formula (I) or (I.a)followed by evaporation of the solvent by thermal treatment,
(e) Surface doping of a layer of a hole transport material by a layer of at least one compound of general formula (I) or (I.a) applied to one or both surfaces of the layer of a hole transport material,
(f) Preparing a solution of a hole transport material and at least one compound of general formula (I) or (I.a) and forming a film from the solution.
